# EUROPEAN PATENT APPLICATION

(11) **EP 4 770 303 A1**
(43) Date of publication of application: **01.07.2026**
(21) Application number: 25211331.1
(22) Date of filing: 27.10.2025
(51) Int. Cl.: H10B 12/00, G11C 11/405, H10D 30/67

(54) **SEMICONDUCTOR DEVICES**

(30) Priority: 24.12.2024 KR 20240195310
(71) Applicant: Samsung Electronics Co., Ltd., Suwon-si, Gyeonggi-do 16677 (KR)
(72) Inventor: KANG, Minju, 16677 Suwon-si, Gyeonggi-do (KR); KANG, Sujin, 16677 Suwon-si, Gyeonggi-do (KR); KIM, Minsoo, 16677 Suwon-si, Gyeonggi-do (KR); KIM, Seunghoon, 16677 Suwon-si, Gyeonggi-do (KR); KIM, Yongkwan, 16677 Suwon-si, Gyeonggi-do (KR); KIM, Huijung, 16677 Suwon-si, Gyeonggi-do (KR); LEE, Hyunjin, 16677 Suwon-si, Gyeonggi-do (KR); CHA, Inho, 16677 Suwon-si, Gyeonggi-do (KR); CHAE, Heejae, 16677 Suwon-si, Gyeonggi-do (KR)
(74) Representative: Kuhnen & Wacker Patent- und Rechtsanwaltsbüro PartG mbB

(57) **Abstract**

A semiconductor device includes a bit line on a substrate, a plate line on the substrate and spaced apart from the bit line in a first direction substantially parallel to an upper surface of the substrate facing the bit line, a first channel between the bit line and the plate line, a first word line wherein the first channel is between the first word line and the substrate and extending in a second direction substantially parallel to the upper surface of the substrate and crossing the first direction, a second channel between the first channel and the substrate, a data storage pattern between the bit line and the plate line at a same distance from the substrate as the second channel, and a second word line between the second channel and the substrate and extending in the second direction.

## Description

### CROSS-REFERENCE TO RELATED APPLICATION

This application claims priority to Korean Patent Application No. 10-2024-0195310 filed on December 24, 2024 in the Korean Intellectual Property Office, the disclosure of which is hereby incorporated by reference in its entirety.

### FIELD

Example embodiments of the present disclosure relate to a semiconductor device. More particularly, example embodiments of the present disclosure relate to a memory device.

### BACKGROUND

A DRAM device includes word lines, bit lines, channels and capacitors, and the capacitors have a large volume in order to have a high capacitance meaning that the degree of integration the DRAM device may be reduced. If the capacitors extend in the horizontal direction and not in the vertical direction, the processes for forming the capacitors become more challenging.

### SUMMARY

Example embodiments provide a semiconductor device having improved characteristics.

According to some embodiments of the present disclosure, there is provided a semiconductor device. The semiconductor device may include a bit line on a substrate, a plate line on the substrate and spaced apart from the bit line in a first direction substantially parallel to an upper surface of the substrate facing the bit line, a first channel between the bit line and the plate line, a first word line wherein the first channel is between the first word line and the substrate, the first word line extending in a second direction substantially parallel to the upper surface of the substrate and crossing the first direction, a second channel between the first channel and the substrate, a data storage pattern between the bit line and the plate line at a same distance from the substrate as the second channel, and a second word line between the second channel and the substrate, the second word line extending in the second direction.

According to some embodiments of the present disclosure, there is provided a semiconductor device. The semiconductor device may include a bit line, a plate line, a first transistor, a second transistor, and a data storage pattern. The bit line may be disposed on a substrate. The plate line may be disposed on the substrate and may be spaced apart from the bit line in a first direction substantially parallel to an upper surface of the substrate facing the bit line. The first transistor may include a first channel between the bit line and the plate line, first and second source/drain regions at opposite ends of the first channel, respectively, in the first direction, the first and second source/drain regions contacting the bit line and the plate line, respectively, a first gate insulation pattern on the first channel and the first and second source/drain regions, and a first gate electrode on the first gate insulation pattern, wherein the first gate insulation pattern is between the channel and the first gate electrode. The second transistor may include a second channel between the first channel and the substrate, third and fourth source/drain regions at opposite ends of the second channel, respectively, in the first direction, a second gate insulation pattern between the substrate and the second channel and the third and fourth source/drain regions, and a second gate electrode between the second gate insulation pattern and the substrate. The data storage pattern may be disposed at a same distance from the substrate as the second channel and may contact the third source/drain. The fourth source/drain region may contact the bit line.

According to some embodiments of the present disclosure, there is provided a semiconductor device. The semiconductor device may include bit lines, a first plate line, first channels, first word lines, first data storage patterns and second word lines. The bit lines may be disposed on a substrate, and each of the bit lines may extend in a vertical substantially perpendicular to an upper surface of the substrate facing the bit lines. The bit lines may be spaced apart from each other in a first direction substantially parallel to the upper surface of the substrate. The first plate line may be disposed on the substrate and may be spaced apart from the bit lines in a second direction substantially parallel to the upper surface of the substrate and crossing the first direction. The first plate line may extend in the vertical direction and in the first direction. The first channels may be disposed between each of the bit lines and the first plate line, and may be spaced apart from each other in the vertical direction. The first word lines may be disposed on one of the first channels farthest from the substrate and may be spaced apart from each other in the vertical direction. Each of the first word lines may extend in the first direction. The first data storage patterns may be disposed at a same distance from the substrate as the second channels, respectively. The second word lines may be spaced apart from each other in the vertical direction between the second channels, and each of the second word lines may extend in the first direction.

The semiconductor device in accordance with some embodiments may include a data storage pattern that may be formed with a small size during the formation of the channel, instead of a capacitor, and thus may have an improved degree of integration and operation characteristics.

### BRIEF DESCRIPTION OF THE DRAWINGS

FIGS. 1 to 4 are a plan view and cross-sectional views illustrating a semiconductor device in accordance with some embodiments of the present disclosure.
FIG. 5 is a schematic perspective view illustrating a structure and a layout of a unit cell included in the semiconductor device, and FIG. 6 is an equivalent circuit diagram of the unit cell.
FIGS. 7 to 52 are plan views and cross-sectional views illustrating a method of manufacturing a semiconductor device in accordance with some embodiments.

### DETAILED DESCRIPTION

The above and other aspects and features of a semiconductor device and a method of manufacturing the same in accordance with example embodiments will become readily understood from detail descriptions that follow, with reference to the accompanying drawings. It will be understood that, although the terms "first," "second," and/or "third" may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second or third element, component, region, layer or section without departing from the teachings of the present disclosure.

Hereinafter, in the specification (and not necessarily in the claims), a vertical direction that is substantially perpendicular to an upper surface of a substrate may be referred to as a first direction D1, and two intersecting directions among horizontal directions that are substantially parallel to the upper surface of the substrate may be referred to as second and third directions D2 and D3, respectively. In example embodiments, the second and third directions D2 and D3 are substantially perpendicular to each other. Each of the first to third directions D1, D2 and D3 may include not only a direction shown in the drawings but also a direction opposite thereto.

The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items. The term "connected" may be used herein to refer to a physical and/or electrical connection. When components or layers are referred to herein as "directly" on, or "in direct contact" or "directly connected," no intervening components or layers are present. Likewise, when components are "immediately" adjacent to one another, no intervening components may be present.

The term "surrounding" or "covering" or "filling" as may be used herein may not require completely surrounding or covering or filling the described elements or layers, but may, for example, refer to partially surrounding or covering or filling the described elements or layers, for example, with voids, spaces, or other discontinuities throughout. The term "exposed," may be used to describe relationships between elements and/or certain intermediate processes in fabricating a completed semiconductor device, but may not necessarily require exposure of the particular region, layer, structure or other element in the context of the completed device.

It will be understood that spatially relative terms such as "above," "upper," "upper portion," "upper surface," "below," "lower," "lower portion," "lower surface," "side surface," and the like may be denoted by reference numerals and refer to the drawings, except where otherwise indicated. It will be understood that such spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

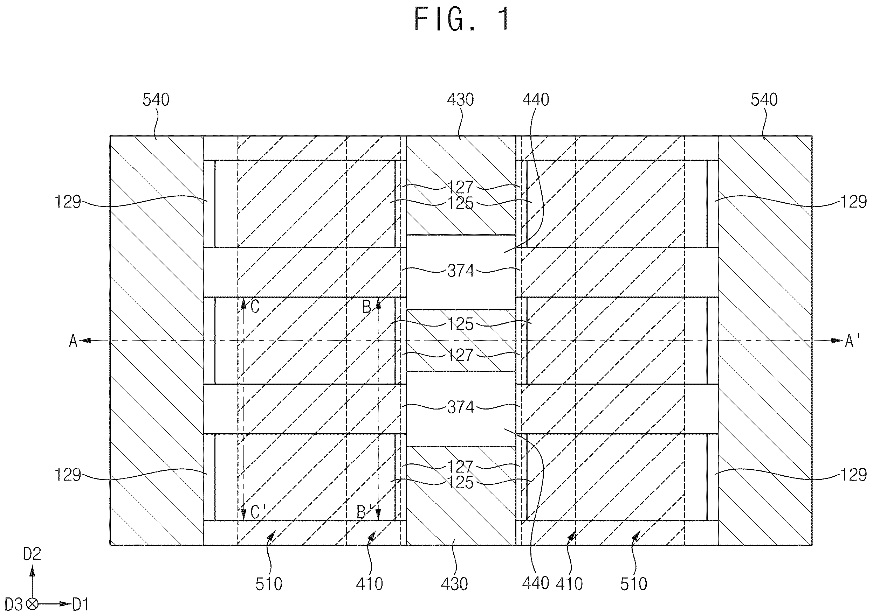

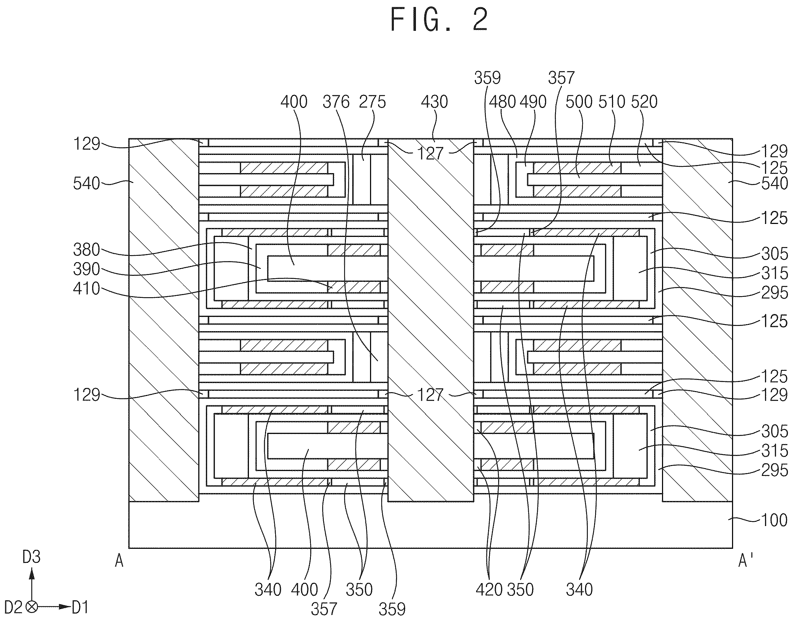

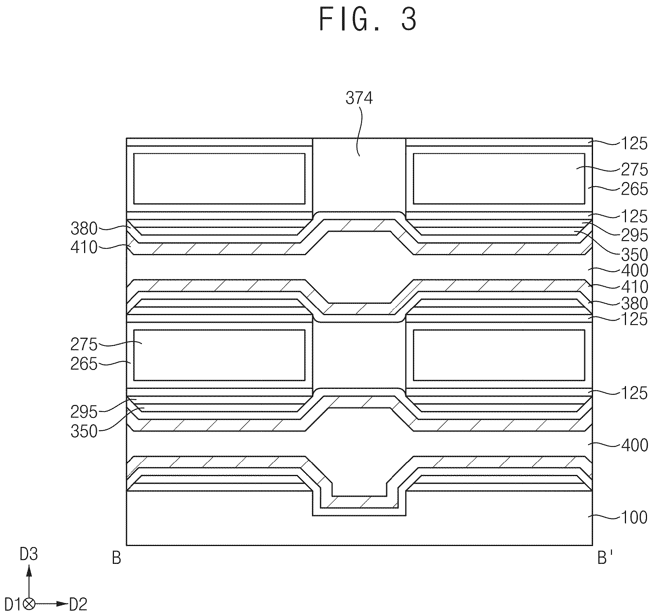

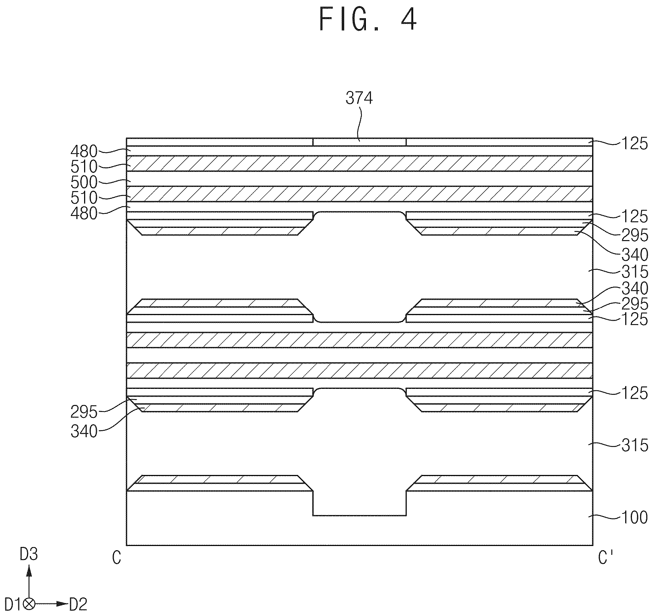

FIGS. 1 to 4 are a plan view and cross-sectional views illustrating a semiconductor device in accordance with example embodiments. Particularly, FIG. 1 is the plan view, FIG. 2 is a cross-sectional view taken along line A-A' of FIG. 1, FIG. 3 is a cross-sectional view taken along line B-B' of FIG. 1, and FIG. 4 is a cross-sectional view taken along line C-C' of FIG. 1.

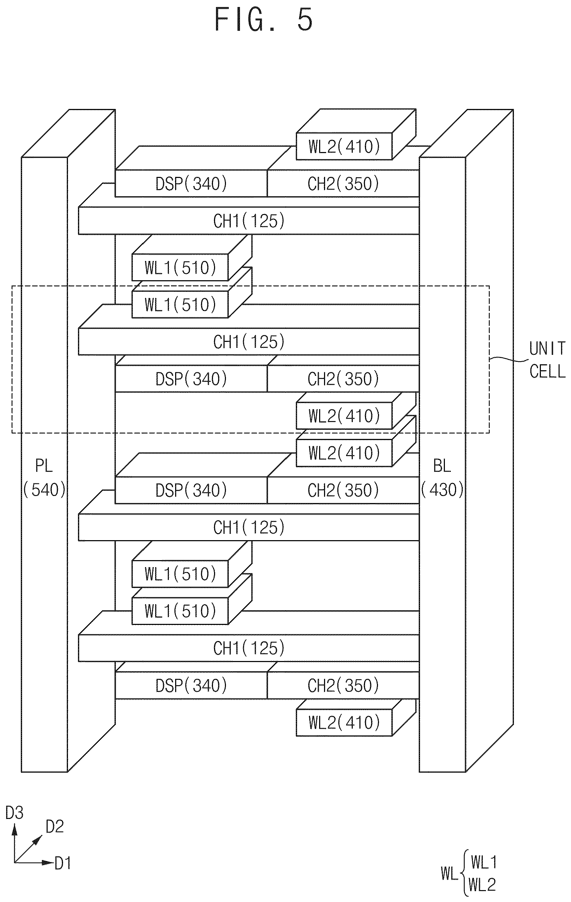

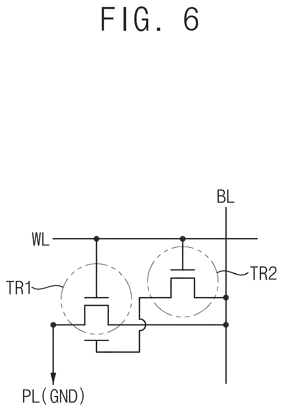

FIG. 5 is a schematic perspective view illustrating a structure and a layout of a unit cell included in the semiconductor device, and FIG. 6 is an equivalent circuit diagram of the unit cell.

Referring to FIGS. 1 to 4, the semiconductor device may include first and second word lines 510 and 410, first and second channels 125 and 350, a data storage pattern 340, a bit line 430 and a plate line 540 on a substrate 100.

The semiconductor device may further include first and second gate insulation patterns 480 and 380, first and second capping patterns 520 and 420, a division layer 440, a high-k dielectric pattern 295, and first to tenth insulation patterns 265, 275, 305, 315, 376, 390, 400, 374, 490 and 500.

In example embodiments, each of the bit line 430 and the division layer 440 may contact an upper surface of the substrate 100 and extend in the third direction D3. The bit line 430 and the division layer 440 may be alternately and repeatedly disposed in the second direction D2, and may contact each other. In an example embodiment, an upper surface of the bit line 430 may be substantially coplanar with an upper surface of the division layer 440. In example embodiments, a plurality of bit lines 430 may be spaced apart from each other in the first direction D1, and a plurality of division layers 440 may be spaced apart from each other in the first direction D1.

The bit line 430 may include a conductive material, e.g., a metal, a metal nitride, a metal silicide, doped polysilicon, etc., and the division layer 440 may include an oxide, e.g., silicon oxide.

In example embodiments, the plate line 540 may contact an upper surface of the substrate 100, and may extend in the third direction D3, and may also extend in the second direction D2. The plate line 540 and the bit line 430 may be alternately and repeatedly disposed in the first direction D1, and may be spaced apart from each other in the first direction D1. In an example embodiment, an upper surface of the plate line 540 may be substantially coplanar with the upper surfaces of the bit line 430 and the division layer 440.

In example embodiments, a ground voltage may be applied to the plate line 540. That is, the plate line 540 may be maintained in a grounded state.

The plate line 540 may include a metal, e.g., tungsten, ruthenium, molybdenum, etc., or a metal nitride, e.g., titanium nitride, tantalum nitride, etc.

The first channel 125 may be disposed between and contact neighboring ones of the bit line 430 and the plate line 540, and a plurality of first channels 125 may be spaced apart from each other in the second direction D2. Additionally, a plurality of first channels 125 may be spaced apart from each other in the third direction D3 on the upper surface of the substrate 100. In example embodiments, the first channel 125 may have a shape of a flat plate including upper and lower surfaces in the horizontal direction.

The first channel 125 may include a single crystalline semiconductor material, e.g., single crystalline silicon, single crystalline silicon-germanium, etc.

In example embodiments, first and second impurity regions 127 and 129 may be disposed at opposite ends, respectively, of the first channel 125 in the first direction D1. The first impurity region 127 may contact a sidewall of the bit line 430, and the second impurity region 129 may contact a sidewall of the plate line 540.

In an example embodiment, each of the first and second impurity regions 127 and 129 may include p-type impurities, e.g., boron, aluminum, etc. Alternatively, each of the first and second impurity regions 127 and 129 may include n-type impurities, e.g., phosphorous, arsenic, etc.

FIGS. 2 to 4 show that the first channels 125 are disposed at four levels, respectively, however, the inventive concept is not limited thereto, and the first channels 125 may be disposed at more or less than four levels, respectively.

The tenth insulation pattern 500 may extend in the second direction D2 between ones of the first channels neighboring in the third direction D3, and a first sidewall in the first direction D1 of the tenth insulation pattern 500 may contact the sidewall of the plate line 540. Thus, a plurality of tenth insulation patterns 500 may be spaced apart from each other in the third direction D3, and a plurality of tenth insulation patterns 500 may also be spaced apart from each other in the first direction D1. The tenth insulation pattern 500 may include an oxide, e.g., silicon oxide.

The first word lines 510 may extend in the second direction D2, and may contact upper and lower surfaces, respectively, of a central portion in the first direction D1 of the tenth insulation pattern 500. Thus, two first word lines 510, that is, an upper first word line 510 and a lower first word line 510 may be spaced apart from each other by the tenth insulation pattern 500 between ones of the first channels 125 neighboring in the third direction D3. Each of the first word lines 510 may include a metal, e.g., tungsten, ruthenium, molybdenum, etc., or a metal nitride, e.g., titanium nitride, tantalum nitride, etc.

The first capping patterns 520 may extend in the second direction D2, and may contact upper and lower surfaces, respectively, of a first end portion in the first direction D1 of the tenth insulation pattern 500. The first capping patterns 520 may also contact the first word lines 510, respectively. Thus, two first capping patterns 520, that is, an upper first capping pattern 520 and a lower first capping pattern 520 may be spaced apart from each other by the tenth insulation pattern 500 between the ones of the first channels 125 neighboring in the third direction D3. Each of the first capping patterns 520 may contact the sidewall of the plate line 540. Each of the first capping patterns 520 may include an insulating nitride, e.g., silicon nitride.

The ninth insulation pattern 490 may extend in the second direction D2, and may contact upper and lower surfaces and a sidewall of a second end portion in the first direction D1 of the tenth insulation pattern 500. The ninth insulation pattern 490 may also contact the first word lines 510. Thus, a single ninth insulation pattern 490 may be disposed between the ones of the first channels 125 neighboring in the third direction D3. The ninth insulation pattern 490 may include an insulating nitride, e.g., silicon nitride.

The first gate insulation pattern 480 may be disposed between and contact the ones of the first channels 125 neighboring in the third direction D3. The first gate insulation pattern 480 may extend in the second direction D2, and may cover upper surfaces of the upper first capping pattern 520 and the upper first word line 510, upper and lower surfaces and a sidewall in the first direction D1 of the ninth insulation pattern 490, and lower surfaces of the lower first capping pattern 520 and the lower first word line 510. Thus, a single first gate insulation pattern 480 may be disposed between the ones of the first channels 125 neighboring in the third direction D3.

In example embodiments, the first gate insulation pattern 480 may include an upper portion contacting the upper surfaces of the upper first capping pattern 520 and the upper first word line 510 and the upper surface and an upper portion of the sidewall in the first direction D1 of the ninth insulation pattern 490, and a lower portion contacting the lower surfaces of the lower first capping pattern 520 and the lower first word line 510 and the lower surface and a lower portion of the sidewall in the first direction D1 of the ninth insulation pattern 490. A sidewall in the first direction D1 of each of the upper and lower portions of the first gate insulation pattern 480 may contact the sidewall of the plate line 540.

The first gate insulation pattern 480 may include, e.g., silicon oxide, or a metal oxide, e.g., aluminum oxide, hafnium oxide, zirconium oxide, lanthanum oxide, etc.

A portion of the first word line 510 overlapping the first channel 125 in the third direction D3 may be defined as a first gate electrode, and the first gate electrode and the first gate insulation pattern 480 contacting the first gate electrode may collectively form a first gate structure. Components or layers described with reference to "overlap" in a particular direction may be at least partially obstructed by one another when viewed along a line extending in the particular direction or in a plane perpendicular to the particular direction. The first gate structure and the first channel 125 may collectively form a first transistor, and the first and second impurity regions 127 and 129 at opposite ends, respectively, in the first direction D1 of the first channel 125 may serve as first and second source/drain regions, respectively, of the first transistor.

The second insulation pattern 275 and the fifth insulation pattern 376 may be disposed in the first direction D1 between the ones of the first channels 125 neighboring in the third direction D3. The first insulation pattern 265 may cover upper and lower surfaces and opposite sidewalls in the second direction D2 of the second insulation pattern 275 and upper and lower surfaces and opposite sidewalls in the second direction D2 of the fifth insulation pattern 376, and may contact the ones of the first channels 125 neighboring in the third direction D3.

In example embodiments, a first sidewall in the first direction D1 of the first insulation pattern 265 and a first sidewall in the first direction D1 of the second insulation pattern 275 may contact a sidewall in the first direction D1 of the first gate insulation pattern 480, a second sidewall in the first direction D1 of the second insulation pattern 275 may contact a first sidewall in the first direction D1 of the fifth insulation pattern 376, and a second sidewall in the first direction D1 of the first insulation pattern 265 and a second sidewall in the first direction D1 of the fifth insulation pattern 376 may contact the sidewall of the bit line 430.

Each of the first and fifth insulation patterns 265 and 376 may include an oxide, e.g., silicon oxide, and the second insulation pattern 275 may include an insulating nitride, e.g., silicon nitride.

The eighth insulation pattern 374 may be disposed between ones of the first insulation patterns 265 neighboring in the second direction D2. The eighth insulation pattern 374 may also contact sidewalls in the second direction D2 of uppermost ones of the first channels 125 neighboring in the second direction D2. The eighth insulation pattern 374 may include an oxide, e.g., silicon oxide.

The seventh insulation pattern 400 may extend in the second direction D2 between the ones of the first channels neighboring in the third direction D3, and a sidewall in the first direction D1 of the seventh insulation pattern 400 may contact the sidewall of the bit line 430. Thus, a plurality of seventh insulation patterns 400 may be spaced apart from each other in the third direction D3, and a plurality of seventh insulation patterns 400 may also be spaced apart from each other in the first direction D1. The seventh insulation pattern 400 may include an oxide, e.g., silicon oxide.

In example embodiments, the seventh and tenth insulation patterns 400 and 500 may be alternately and repeatedly disposed between the ones of the first channels 125 neighboring in the third direction D3. The seventh and tenth insulation patterns 400 and 500 may partially overlap each other in the third direction D3, and an end portion in the first direction D1 of the seventh insulation pattern 400 and an end portion in the first direction D1 of the tenth insulation pattern 500 may not overlap each other in the third direction D3.

The second word lines 410 may extend in the second direction D2, and may contact upper and lower surfaces of a central portion in the first direction D1 of the seventh insulation pattern 400. Thus, two second word lines 410, that is, upper and lower second word lines 410 may be spaced apart from each other by the seventh insulation pattern 400 between the ones of the first channels 125 neighboring in the third direction D3.

In an example embodiment, each of the second word lines 410 may not overlap in the third direction D3 other ones of the second word lines 410 that are disposed over and under each of the second word lines 410. However, the inventive concept is not necessarily limited thereto. Thus, alternatively, each of the second word lines 410 may partially overlap in the third direction D3 other ones of the second word lines 410 that are disposed over and under each of the second word lines 410. Alternatively, a sidewall in the first direction D1 of each of the second word lines 410 may be aligned with sidewalls in the first direction D1 of other ones of the second word lines 410 that are disposed over and under each of the second word lines 410, which is shown in FIG. 2.

A connection line may be further disposed to electrically connect each of the second word lines 410 to a corresponding one of the first word lines 510.

Each of the second word lines 410 may include a metal, e.g., tungsten, ruthenium, molybdenum, etc., or a metal nitride, e.g., titanium nitride, tantalum nitride, etc.

The second capping patterns 420 may extend in the second direction D2, and may contact upper and lower surfaces of a first end portion in the first direction D1. The second capping patterns 420 may also contact the second word lines 410, respectively. Thus, two second capping patterns 420, that is, upper and lower second capping patterns 420 may be spaced apart from each other by the seventh insulation pattern 400 between the ones of the first channels 125 neighboring in the third direction D3. Each of the second capping patterns 420 may contact the sidewall of the bit line 430. In example embodiments, each of the second capping patterns 420 may not overlap the first capping patterns 520 that are disposed over and under the second capping patterns 420.

Each of the second capping patterns 420 may include an insulating nitride, e.g., silicon nitride.

The sixth insulation pattern 390 may extend in the second direction D2, and may contact upper and lower surfaces and a sidewall of a second end portion in the first direction D1 of the seventh insulation pattern 400. The sixth insulation pattern 390 may also contact the second word lines 410. Thus, a single sixth insulation pattern 390 may be disposed between the ones of the first channels 125 neighboring in the third direction D3. The sixth insulation pattern 390 may include an insulating nitride, e.g., silicon nitride.

The second gate insulation pattern 380 may be disposed between the ones of the first channels 125 neighboring in the third direction D3. The second gate insulation pattern 380 may extend in the second direction D2, and may cover upper surfaces of the upper second capping pattern 420 and the upper second word line 410, upper and lower surfaces and a sidewall in the first direction D1 of the sixth insulation pattern 390, and lower surfaces of the lower second capping pattern 420 and the lower second word line 410. Thus, a single second gate insulation pattern 380 may be disposed between the ones of the first channels 125 neighboring in the third direction D3.

In example embodiments, the second gate insulation pattern 380 may include an upper portion contacting the upper surfaces of the upper second capping pattern 420 and the upper second word line 410 and the upper surface and an upper portion of the sidewall in the first direction D1 of the sixth insulation pattern 390, and a lower portion contacting the lower surfaces of the lower second capping pattern 420 and the lower second word line 410 and the lower surface and a lower portion of the sidewall in the first direction D1 of the sixth insulation pattern 390. A sidewall of each of the upper and lower portions of the second gate insulation pattern 380 may contact the sidewall of the bit line 430.

The second gate insulation pattern 380 may include a metal oxide, e.g., aluminum oxide, hafnium oxide, zirconium oxide, etc., or silicon oxide.

The fourth insulation pattern 315 may be disposed between the ones of the first channels 125 neighboring in the third direction D3, and may extend in the second direction D2 and contact a sidewall in the first direction D1 of the second gate insulation pattern 380. The fourth insulation pattern 315 may include an oxide, e.g., silicon oxide.

The second channels 350 may be disposed between the ones of the first channels 125 neighboring in the third direction D3, and may contact upper and lower surfaces, respectively, of the second gate insulation pattern 380. Thus, two second channels 350, that is, upper and lower second channels 350 may be disposed between the ones of the first channels 125 neighboring in the third direction D3. In example embodiments, each of the second channels 350 may have a shape of a flat plate including upper and lower surfaces extending in the horizontal direction.

In example embodiments, each of the second channels 350 may overlap the second word line 410 in the third direction D3. Additionally, each of the second channels 350 may overlap a portion of the first channel 125, particularly, a portion of the first channel 125 adjacent to the bit line 430. In example embodiments, a length in the second direction D2 of each of the second channels 350 may be equal to or less than a length in the second direction D2 of the first channel 125.

Each of the second channels 350 may include an oxide semiconductor material, e.g., indium gallium zinc oxide (IGZO), indium gallium silicon oxide (IGSO), zinc tin oxide (ZTO), indium zinc oxide (IZO), etc. In an example embodiment, each of the second channels 350 may include an n-type oxide semiconductor material doped with impurities, e.g., hydrogen, oxygen, etc. Alternatively, each of the second channels 350 may include a p-type oxide semiconductor material doped with impurities, e.g., hydrogen, oxygen, etc.

In example embodiments, third and fourth impurity regions 357 and 359 may be disposed at opposite ends, respectively, of the second channel 350 in the first direction D1. The third impurity region 357 may contact a sidewall of the data storage pattern 340, and the fourth impurity region 129 may contact a sidewall of the bit line 530.

In an example embodiment, each of the third and fourth impurity regions 357 and 359 may include an n-type oxide semiconductor material doped with impurities, e.g., hydrogen, oxygen, etc. Alternatively, each of the third and fourth impurity regions 357 and 359 may include a p-type oxide semiconductor material doped with impurities, e.g., hydrogen, oxygen, etc. The impurities doped in each of the third and fourth impurity regions 357 and 359 may have the same conductivity type as the impurities doped in the second channel 350, and a concentration of the impurities doped in each of the third and fourth impurity regions 357 and 359 may be greater than a concentration of the impurities doped in the second channel 350.

A portion of the second word line 410 overlapping the second channel 350 in the third direction D3 may be defined as a second gate electrode, and the second gate electrode and the second gate insulation pattern 380 contacting the second gate electrode may collectively form a second gate structure. The second gate structure and the second channel 350 may collectively form a second transistor, and the third and fourth impurity regions 357 and 359 at the opposite ends, respectively, of the second channel 350 may serve third and fourth source/drain regions, respectively, of the second transistor.

The data storage pattern 340 may be disposed between the ones of the first channels 125 neighboring in the third direction D3, and may contact upper surfaces of the second gate insulation pattern 380 and the fourth insulation pattern 315, and lower surfaces of the second gate insulation pattern 380 and the fourth insulation pattern 315. Thus, two data storage patterns 340, that is, upper and lower data storage patterns 340 may be disposed between the ones of the first channels 125 neighboring in the third direction D3.

In example embodiments, each of the data storage patterns 340 may at least partially overlap the word line 510 in the third direction D3. Additionally, each of the data storage patterns 340 may overlap a portion of the first channel 125, particularly, a central portion in the first direction D1 of the first channel 125. In example embodiments, a length in the second direction D2 of each of the data storage patterns 340 may be equal to or less than the length in the second direction D2 of the first channel 125.

In an example embodiment, each of the data storage pattern 340 may include a metal, e.g., tungsten, ruthenium, molybdenum, etc., or a metal nitride, e.g., titanium nitride, tantalum nitride, etc.

Alternatively, each of the data storage pattern 340 may include an n-type oxide semiconductor material doped with impurities, e.g., hydrogen, oxygen, etc., or a p-type oxide semiconductor material doped with impurities, e.g., hydrogen, oxygen, etc. In this case, a concentration of the impurities doped in each of the data storage pattern 340 may be greater than a concentration of the impurities doped in each of the third and fourth impurity regions 357 and 359.

The third insulation pattern 305 may be disposed between the ones of the first channels 125 neighboring in the third direction D3, and may contact the upper and lower surfaces and a sidewall of the fourth insulation pattern 315. The third insulation pattern 305 may also contact the data storage patterns 340. Thus, a single third insulation pattern 305 may be disposed between the ones of the first channels 125 neighboring in the third direction D3.

In example embodiments, the third insulation pattern 305 may overlap a portion of the first channel 125 in the third direction D3. In example embodiments, a length in the second direction D2 of the third insulation pattern 305 may be equal to or less than the length in the second direction D2 of the first channel 125.

The third insulation pattern 305 may include an insulating nitride, e.g., silicon nitride.

The high-k dielectric pattern 295 may be disposed between and contact the ones of the first channels 125 neighboring in the third direction D3, and may cover upper surfaces of the upper second channel 350 and the upper data storage pattern 340, the upper and lower surfaces and the sidewall in the first direction D1 of the fourth insulation pattern 315, and lower surfaces of the lower second channel 350 and the lower data storage pattern 340. Thus, a single high-k dielectric pattern 295 may be disposed between the ones of the first channels 125 neighboring in the third direction D3.

In example embodiments, the high-k dielectric pattern 295 may include an upper portion contacting the upper surfaces of the upper second channel 350 and the upper data storage pattern 340 and the upper surface and an upper portion of the sidewall in the first direction D1 of the fourth insulation pattern 315, and a lower portion contacting the lower surfaces of the lower second channel 350 and the lower data storage pattern 340 and the lower surface and a lower portion of the sidewall in the first direction D1 of the fourth insulation pattern 340. A sidewall in the first direction D1 of each of the upper and lower portions of the high-k dielectric pattern 295 may contact the sidewall of the bit line 430.

In example embodiments, the high-k dielectric pattern 295 may overlap the first channel 125 in the third direction D3. In example embodiments, a length in the first direction D1 of the high-k dielectric pattern 295 may be substantially equal to a length in the first direction D1 of the first channel 125, and a length in the second direction D2 of the high-k dielectric pattern 295 may be equal to or less than the length in the second direction D2 of the first channel 125.

The high-k dielectric pattern 295 may include a metal oxide, e.g., aluminum oxide, hafnium oxide, zirconium oxide, lanthanum oxide, etc.

In example embodiments, the first transistors at the same level may be symmetrically disposed with reference to the bit lines 430 and the division layers 440, and the second transistors at the same level may be symmetrically disposed with reference to the bit lines 430 and the division layers 440.

Thus, the first channels 125 at opposite sides, respectively, in the first direction D1 of the bit lines 430 and the division layers 440 may have a symmetrical shape and be symmetrically disposed to each other, and the second channels 350 at opposite sides, respectively, in the first direction D1 of the bit lines 430 and the division layers 440 may have a symmetrical shape and be symmetrically disposed to each other. Additionally, the first word lines 510 at opposite sides, respectively, in the first direction D1 of the bit lines 430 and the division layers 440 may have a symmetrical shape and be symmetrically disposed to each other, and the second word lines 410 at opposite sides, respectively, in the first direction D1 of the bit lines 430 and the division layers 440 may have a symmetrical shape and be symmetrically disposed to each other.

Referring to FIGS. 1 to 4 together with FIGS. 5 and 6, the semiconductor device may include the bit line BL and the plate line PL spaced apart from each other in the first direction D1, the first channels CH1 disposed between and electrically connected to the bit line BL and the plate line PL, the first word lines WL1 that are spaced apart from each other in the third direction D3 on one of the first channels CH1, e.g., on an upper one of the first channels CH1 and extend in the second direction D2, the second channels CH2 that are spaced apart from each other in the third direction D3 between the first channels CH1 and electrically connected to the bit line BL, the data storage patterns DSP that are disposed at the same level as and electrically connected to the second channels CH2, and the second word lines WL2 that are spaced apart from each other in the third direction D3 between the first channels CH1 and extend in the second direction D2.

The first and second source/drain regions 127 and 129 may be disposed at opposite ends in the first direction D1 of each of the first channels CH1, and may be connected to the bit line BL and the plate line PL, respectively, and the third and fourth source/drain regions 357 and 359 may be disposed at opposite ends in the first direction D1 of each of the second channels CH2, and may be connected to the data storage pattern DSP and the bit line BL, respectively.

The portion of each of the first word lines 510 overlapping the first channel 125 in the third direction D3 may be defined as the first gate electrode, which may form the first gate structure together with the first gate insulation pattern 480. The first gate structure, the first channel 125 and the first and second source/drain regions 127 and 129 may collectively form the first transistor TR1.

The portion of each of the second word lines 410 overlapping the second channel 350 in the third direction D3 may be defined as the second gate electrode, which may form the second gate structure together with the second gate insulation pattern 380. The second gate structure, the second channel 350 and the third and fourth source/drain regions 357 and 359 may collectively form the second transistor TR2.

In the semiconductor device, the first and second transistors TR1 and TR2 and the data storage pattern DSP may collectively form a unit cell, which may be electrically connected to the bit line BL for applying a bit line voltage, the plate line PL for applying a ground voltage, and the first and second word lines WL1 and WL2 for applying word line voltages. The first and second word lines WL1 and WL2 may be electrically connected to each other, and the first and second word lines WL1 and WL2 may apply the same electrical signal, e.g., the same voltage. As a result, three types of electrical signals may be applied to the unit cell through the bit line BL, the plate line PL and the word line WL.

In example embodiments, the first and second source/drain regions 127 and 129 may include a first conductivity type of impurities, e.g., p-type impurities, and thus the first transistor may be a PMOS transistor. The first transistor may serve as a write transistor in the semiconductor device. The third and fourth source/drain regions 357 and 359 may include a second conductivity type of impurities, which is an opposite type of impurities to the first conductivity type of impurities, e.g., n-type impurities, and thus the second transistor may be an NMOS transistor. The second transistor may serve as a read transistor in the semiconductor device.
For example, if a minus voltage is applied to the word line WL, the first transistor that is the PMOS transistor may be turned-on, while the second transistor that is the NMOS transistor may not be turned-on. If a plus voltage is applied to the word line WL, the second transistor that is the NMOS transistor may be turned-on, while the first transistor that is the PMOS transistor may not be turned-on.

In the semiconductor device, according to an amount of charge stored in the data storage pattern DSP connected to the second transistor that is a write transistor, "0" data or "1" data may be detected using a threshold voltage difference of the first transistor that is a read transistor. That is, the semiconductor device may not include a capacitor of a DRAM device, but may include the data storage pattern DSP acting as the capacitor, that is, data storage.

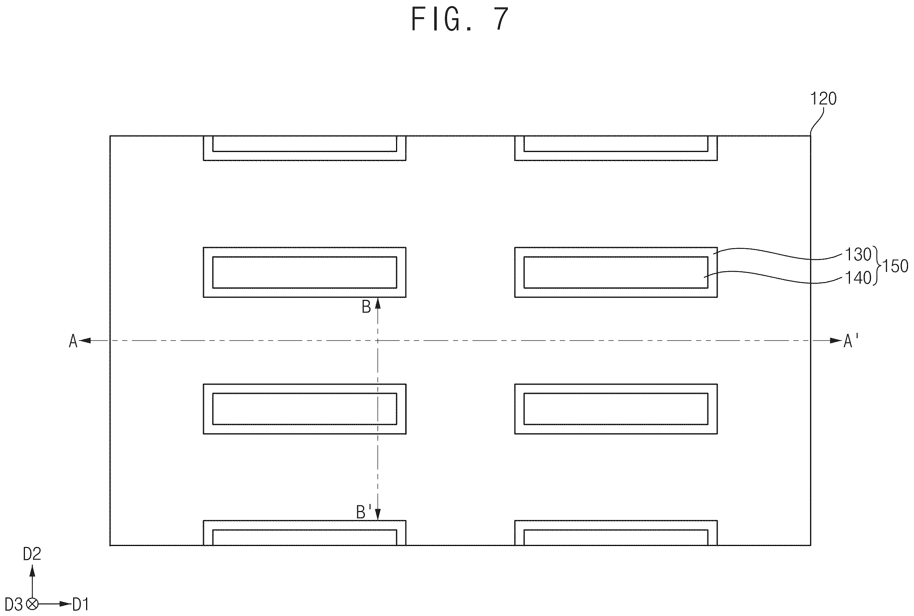

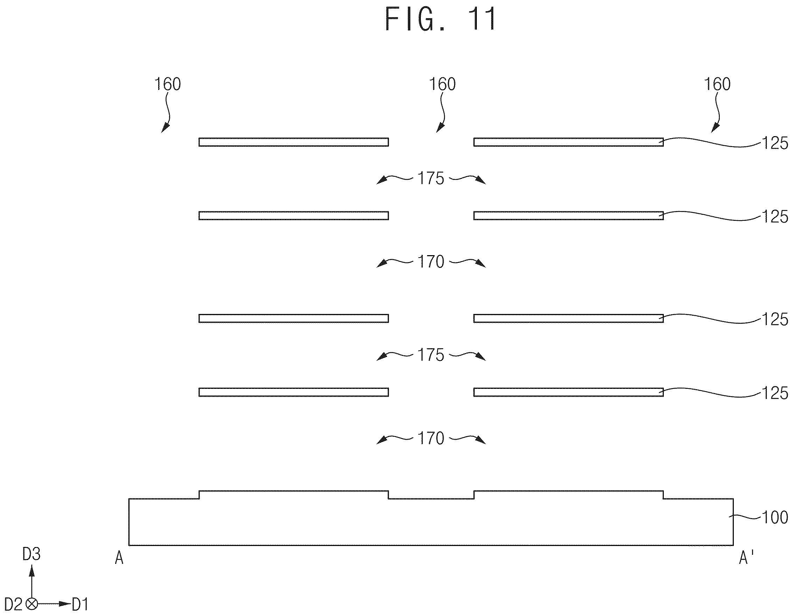

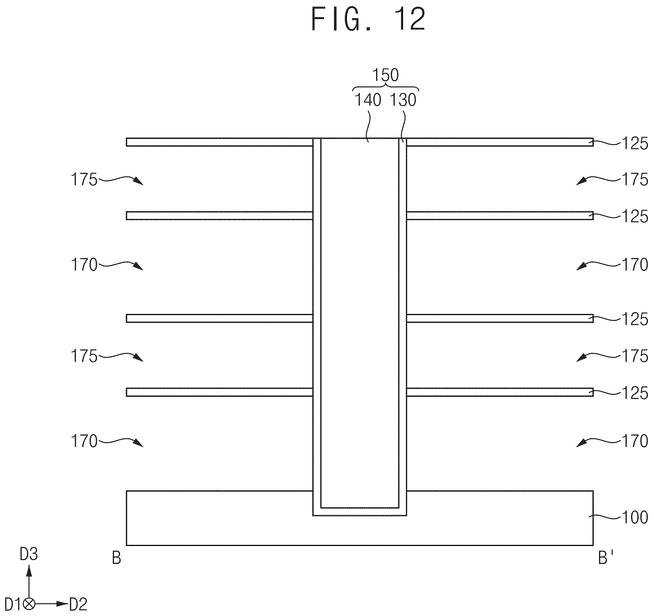

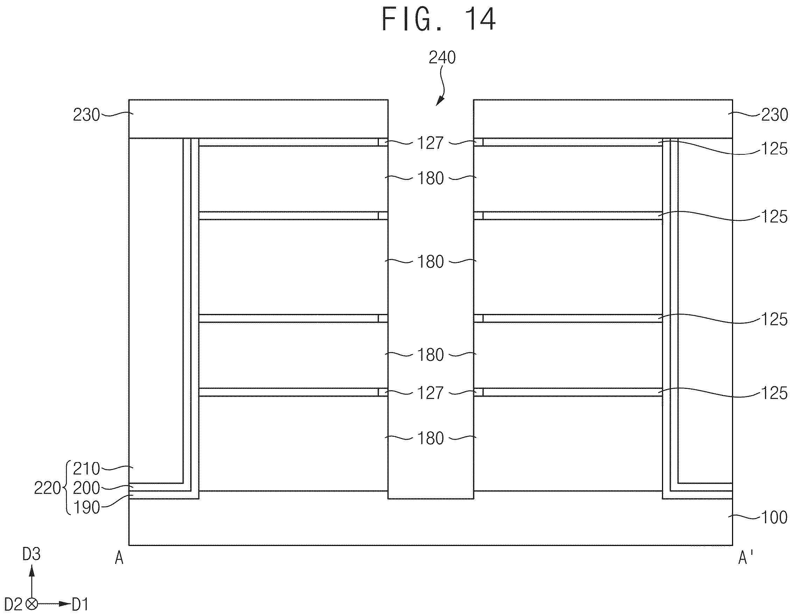

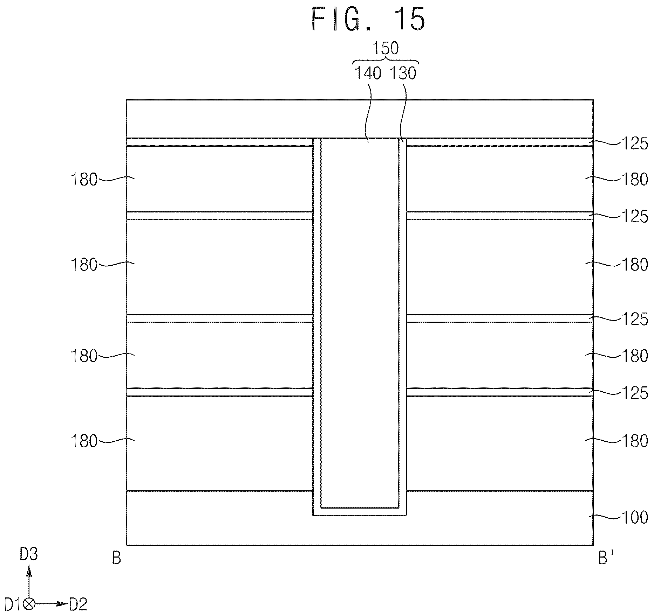

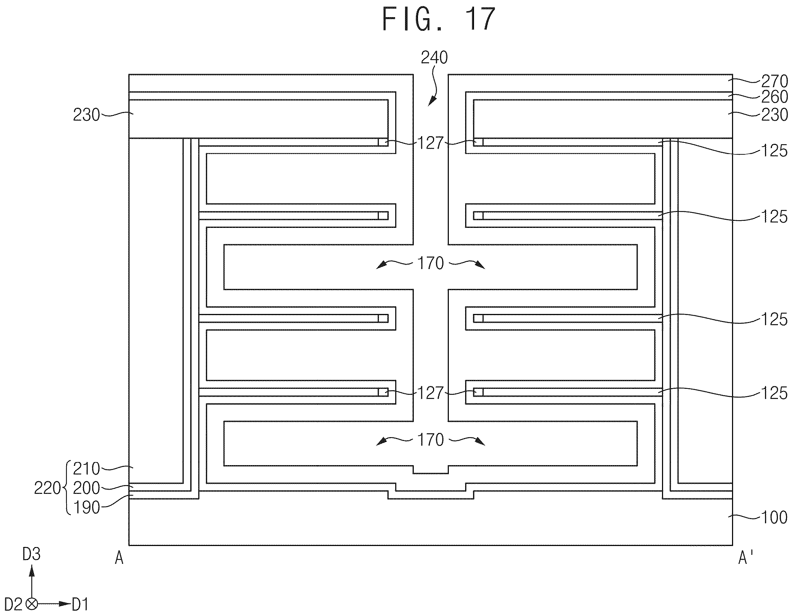

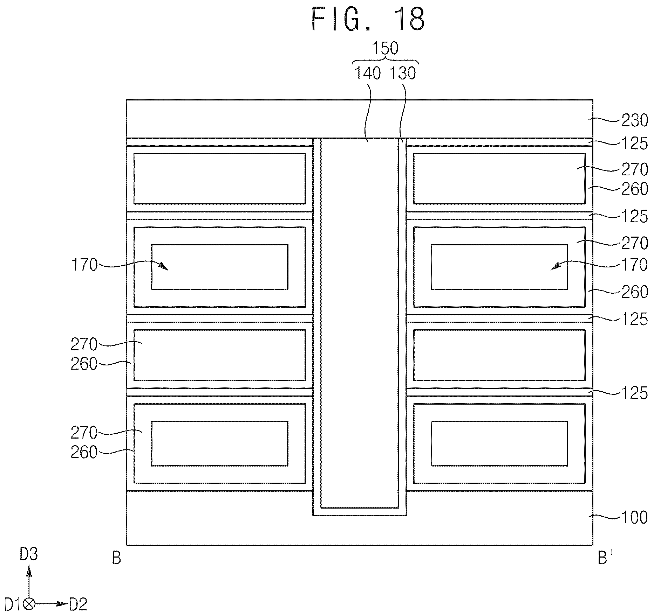

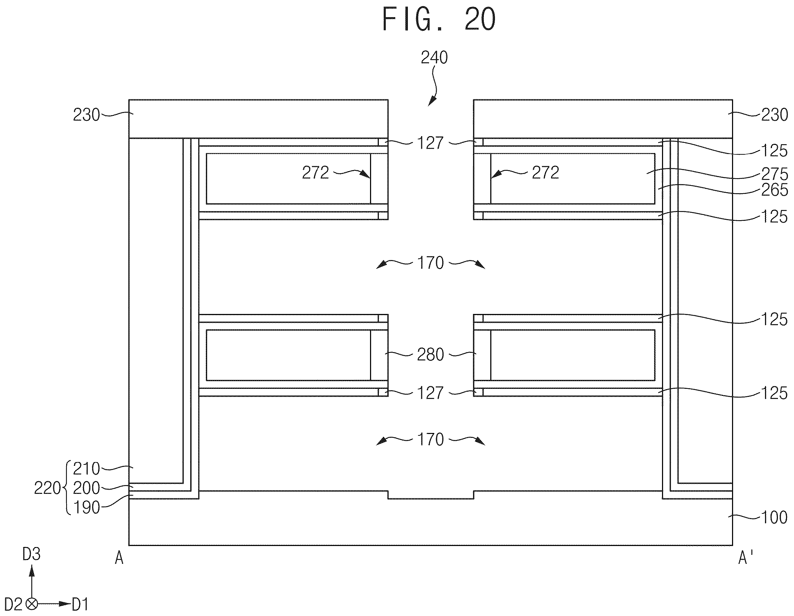

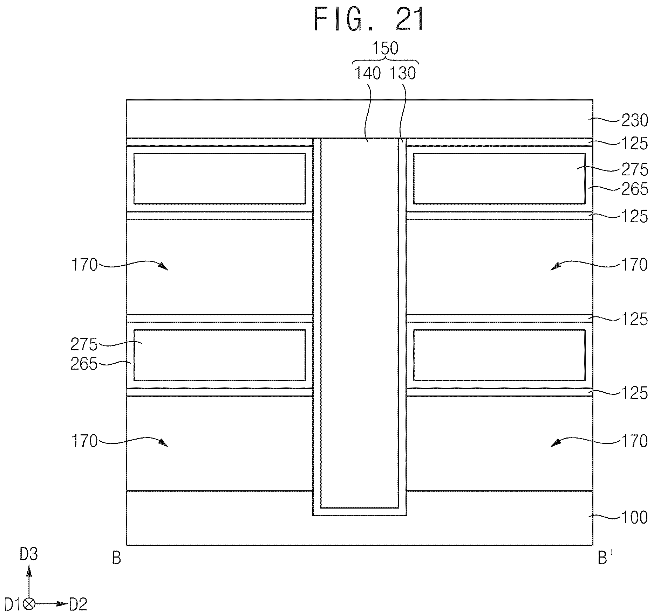

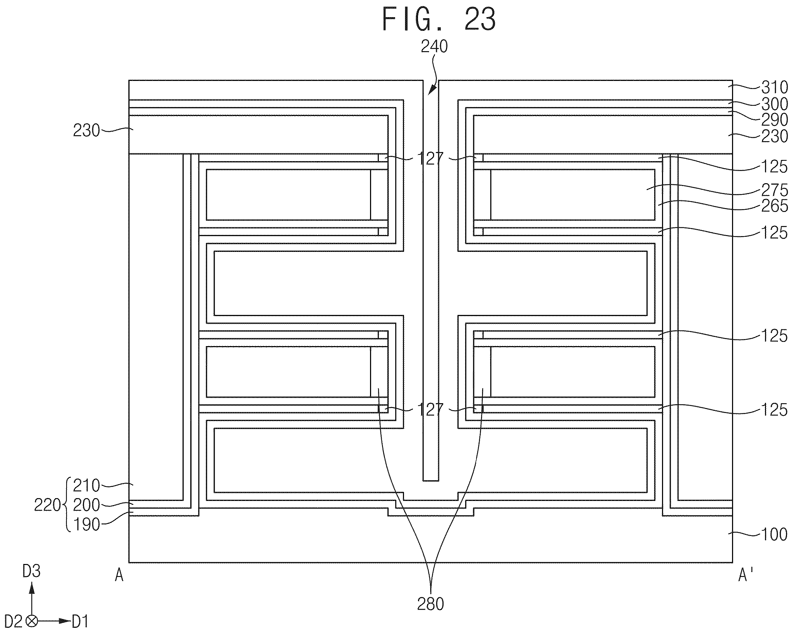

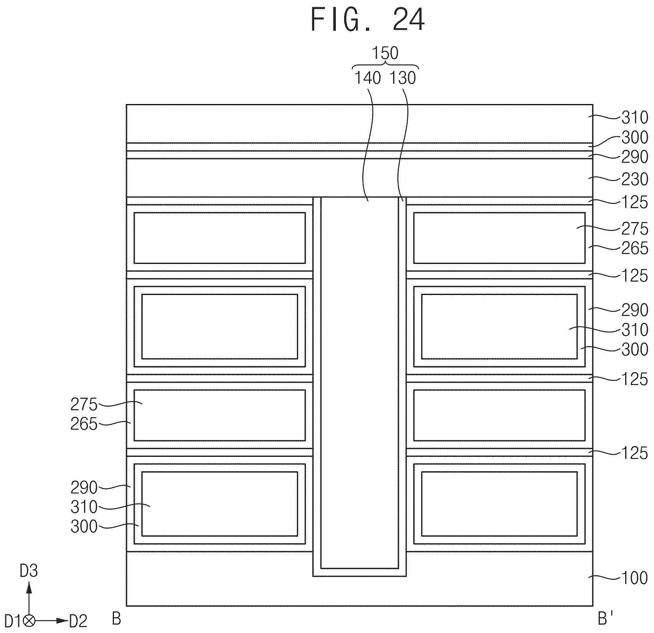

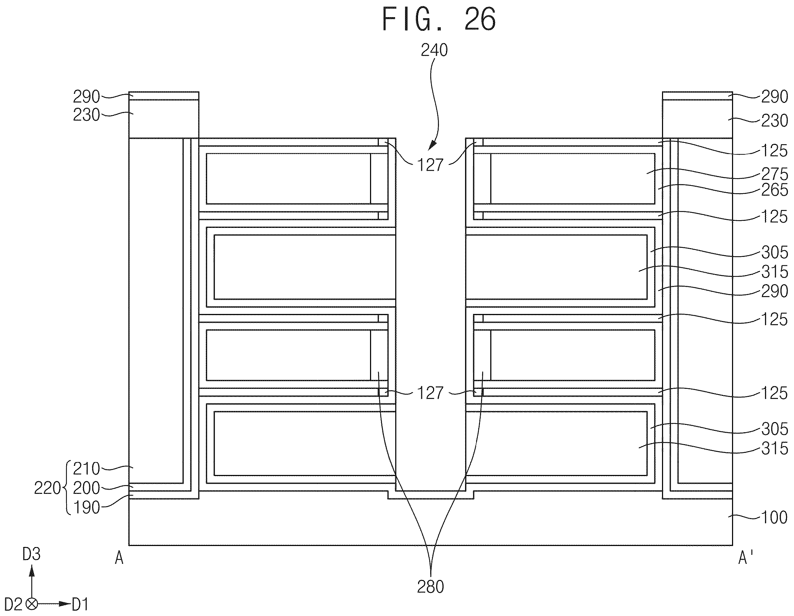

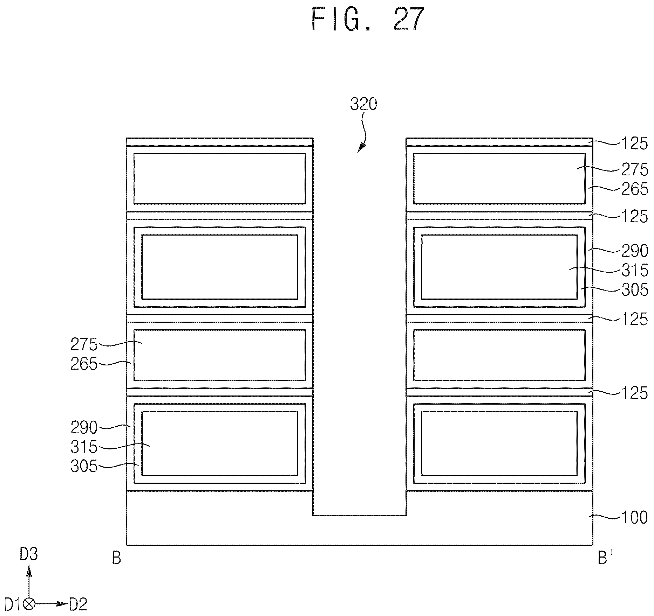

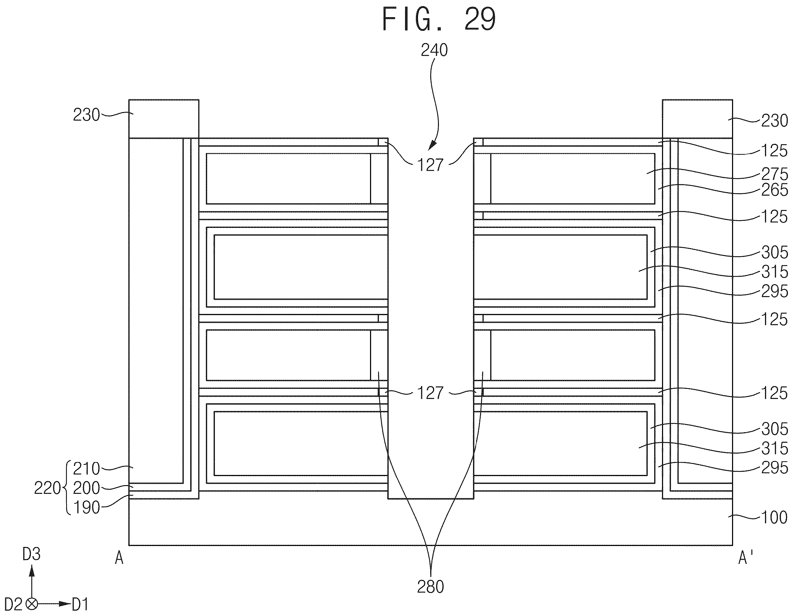

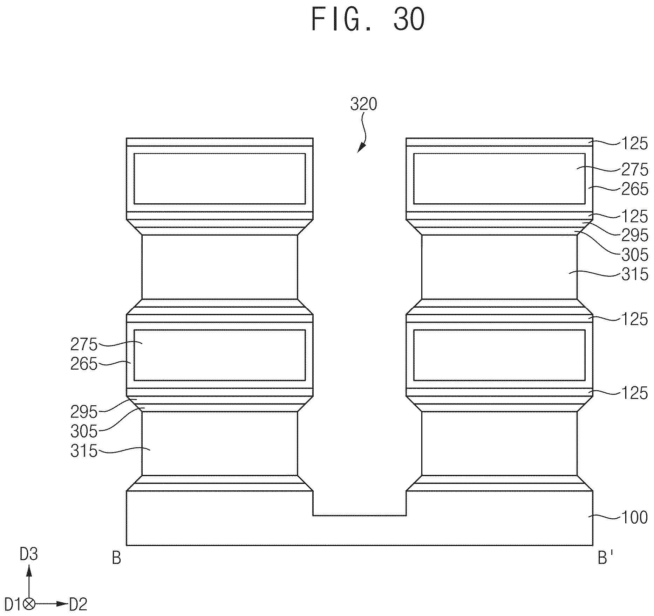

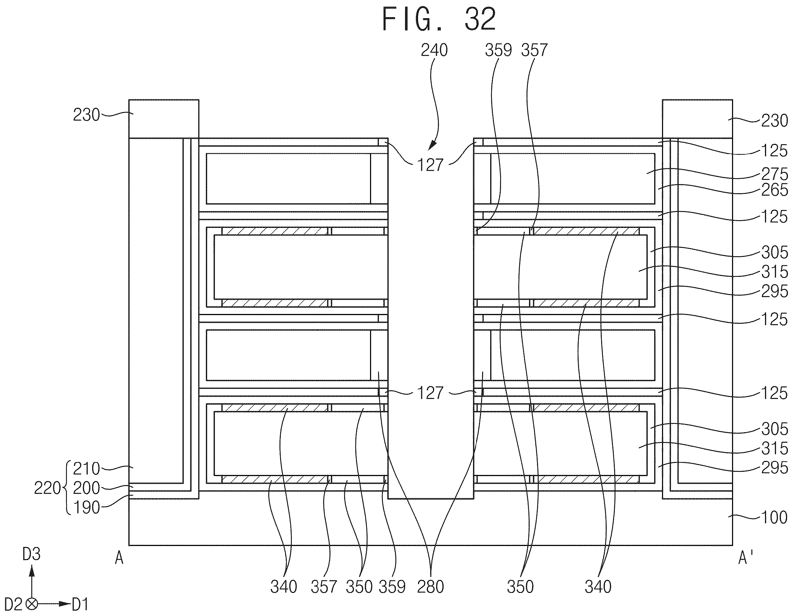

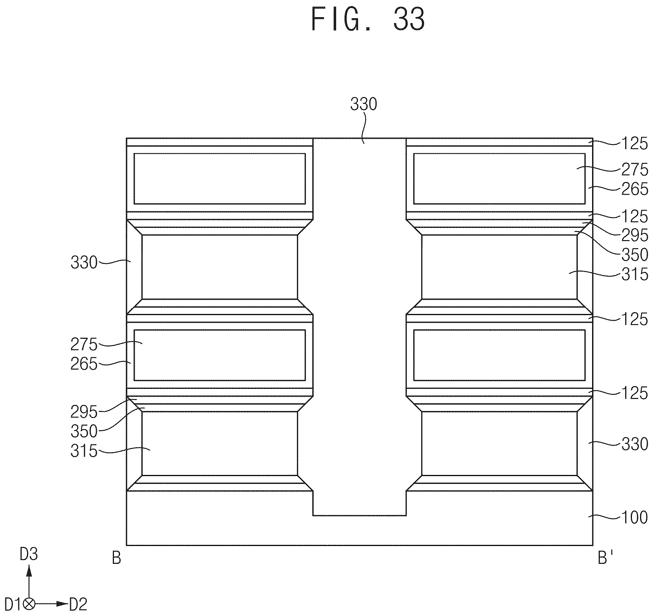

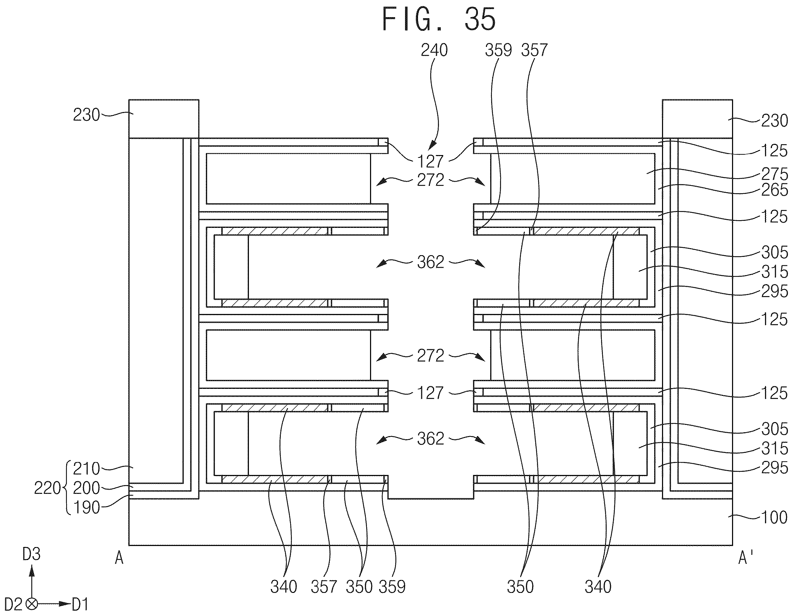

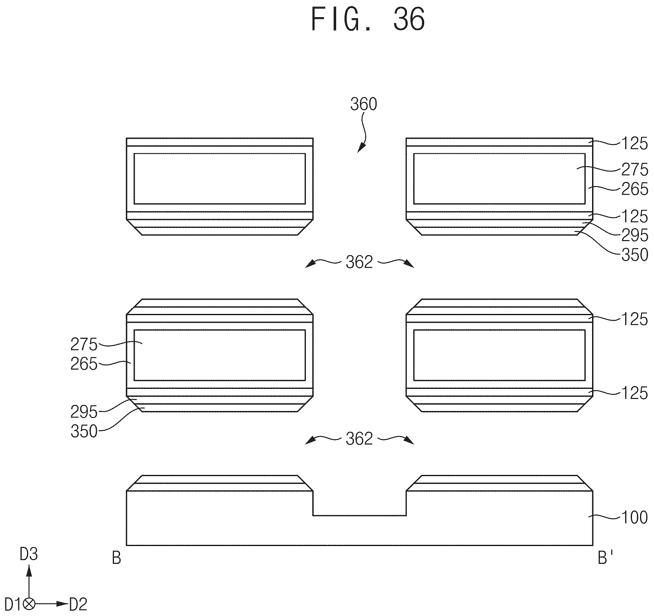

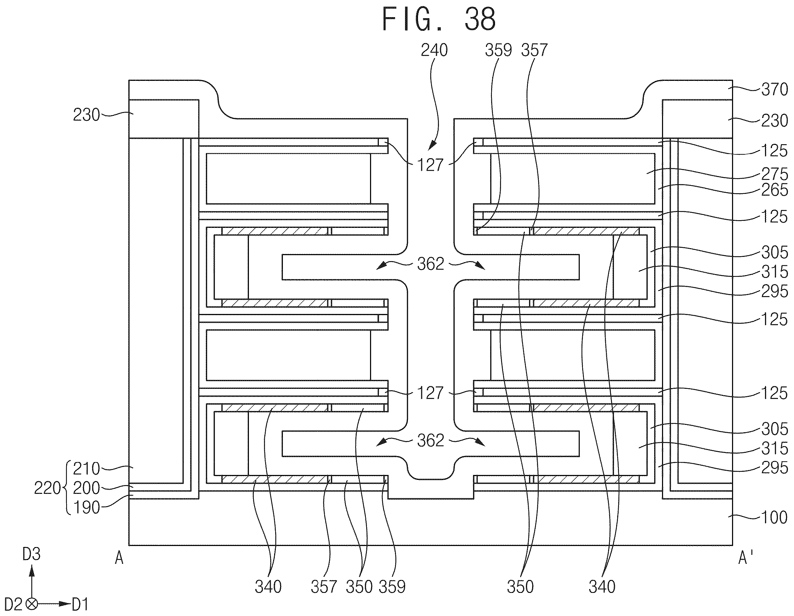

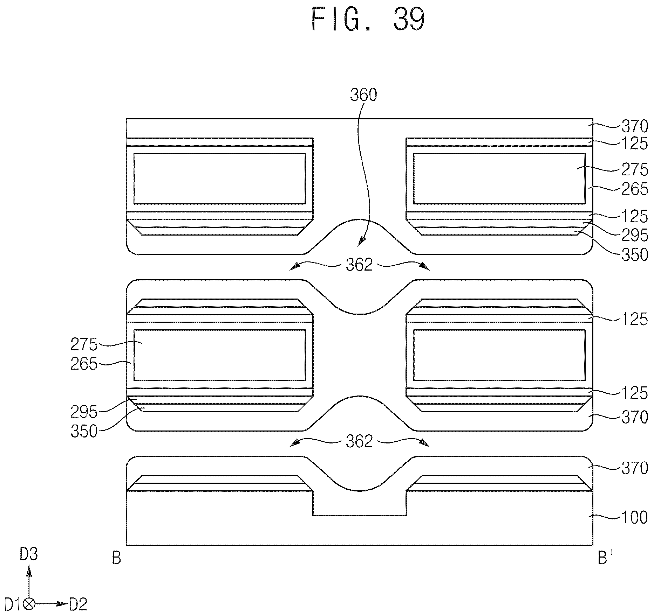

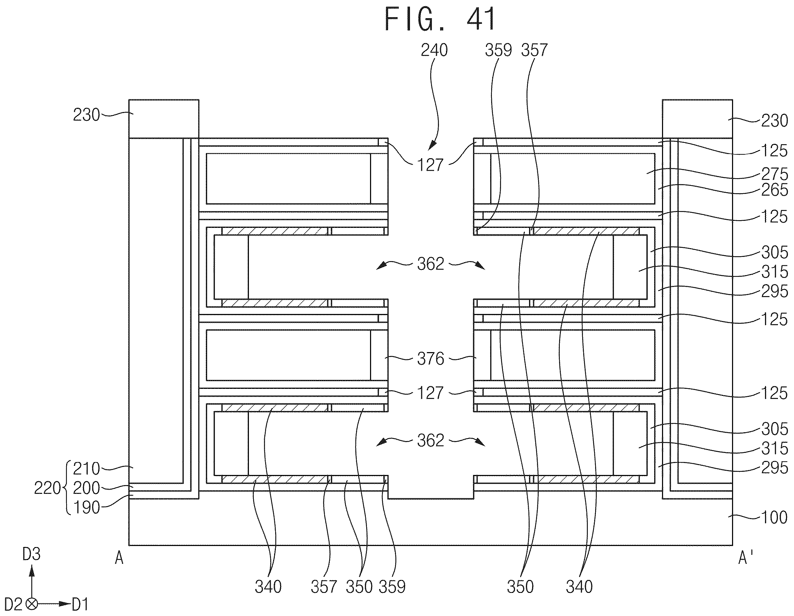

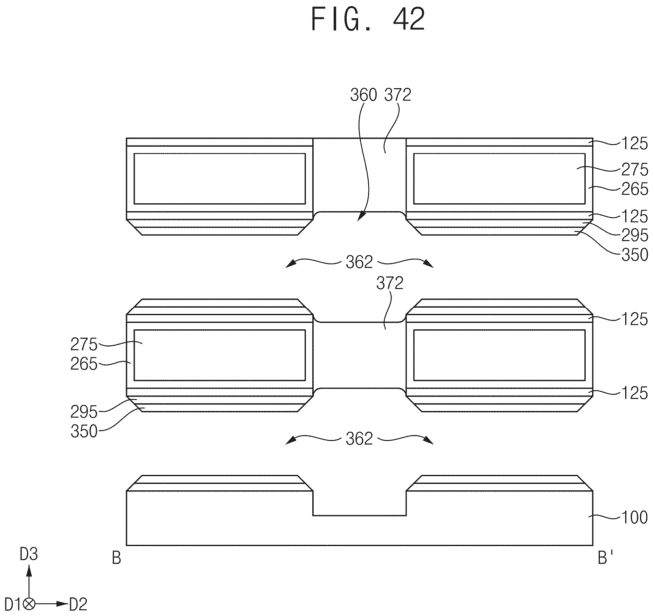

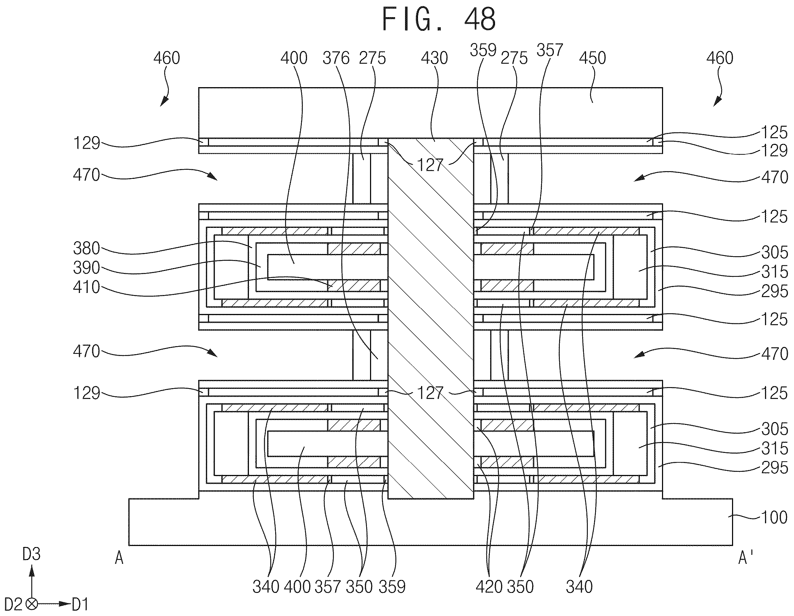

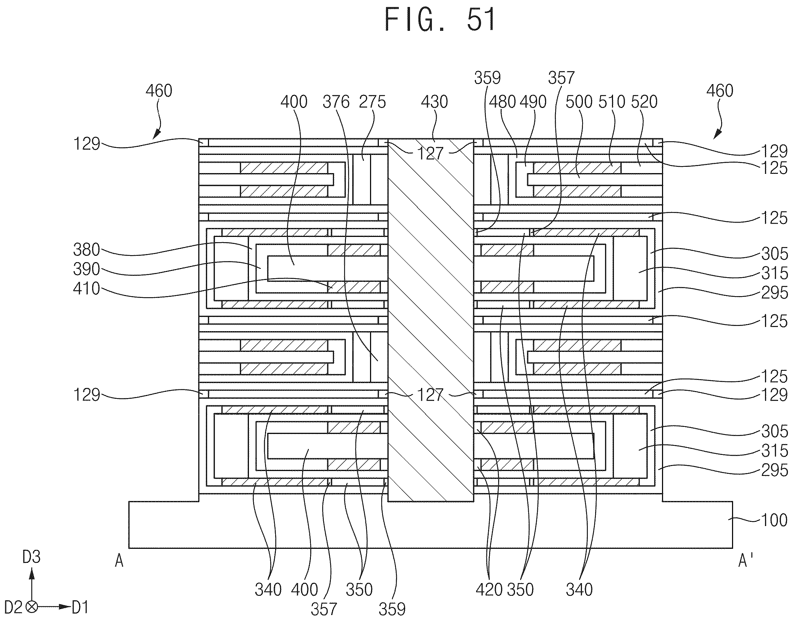

Processes for forming the capacitor is difficult, and the capacitor may have a large volume in order to have a high capacitance. However, the data storage pattern DSP, as illustrated below with reference to FIGS. 7 to 52, may be easily formed when the second channel CH2 is formed. Even if the data storage pattern DSP does not have a large volume, data retention is possible as long as a constant voltage is maintained, which may be achieved by the second channel CH2 included in the write transistor. The second channel CH2 may include an oxide semiconductor material, e.g., IGZO having a low off current characteristics.

Accordingly, the semiconductor device having the unit cell including the data storage pattern DSP instead of the capacitor may have an enhanced integration degree and operation characteristic.

FIGS. 7 to 52 are plan views and cross-sectional views illustrating a method of manufacturing a semiconductor device in accordance with example embodiments.

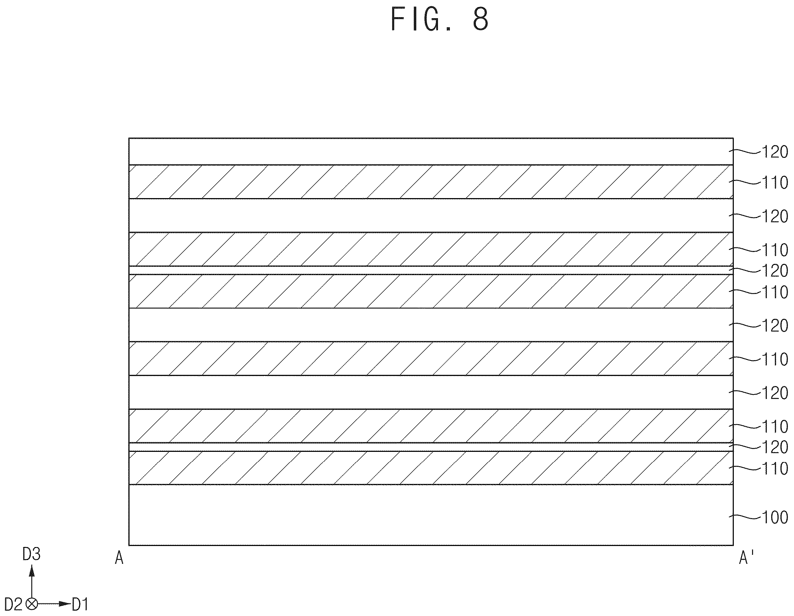

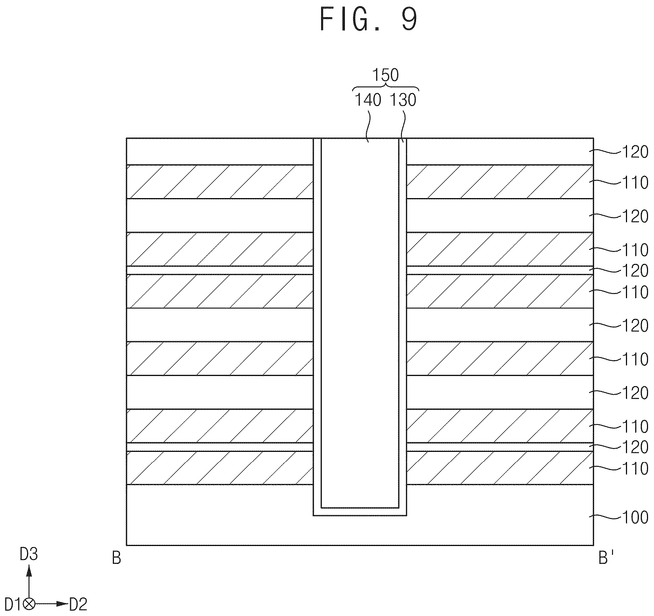

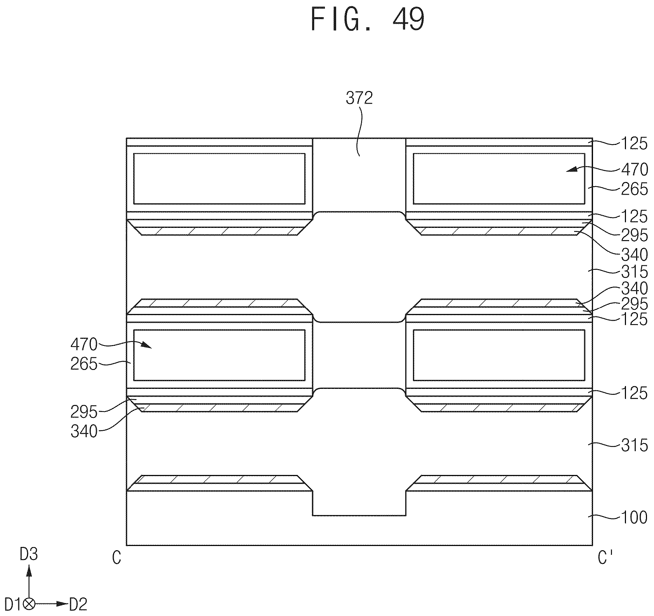

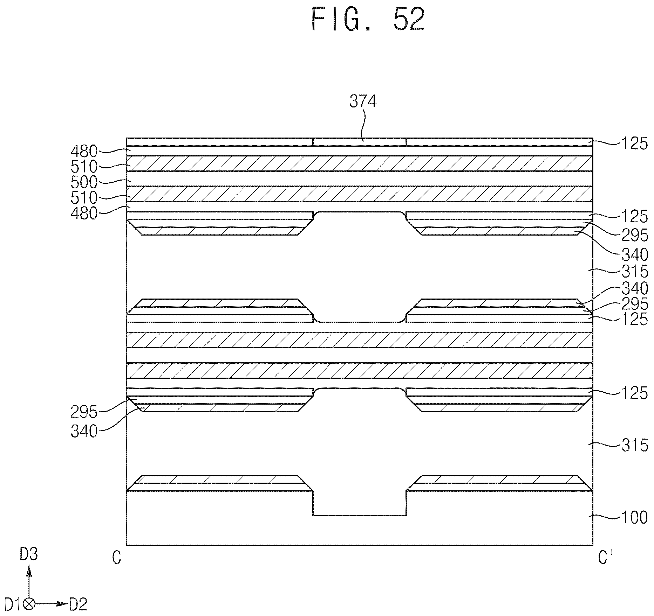

Particularly, FIGS. 7, 10, 13, 16, 19, 22, 25, 28, 31, 34, 37, 40, 45, 47 and 50 are the plan views, FIGS. 8, 11, 14, 17, 20, 23, 26, 29, 32, 35, 38, 41, 43, 46, 48 and 51 are cross-sectional views taken along lines A-A' of corresponding plan views, respectively, FIGS. 9, 12, 15, 18, 21, 24, 27, 30, 33, 36, 39, 42 and 44 are cross-sectional views taken along lines B-B' of corresponding plan views, respectively, and FIGS. 49 and 52 are cross-sectional views taken along lines C-C' of corresponding plan views, respectively.

Referring to FIGS. 7 to 9, a first sacrificial layer 110 and a first channel layer 120 may be alternately and repeatedly stacked in the first direction D1 on a substrate 100 to form a mold layer.

In example embodiments, the first sacrificial layer 110 and the first channel layer 120 may be formed by an epitaxial growth process using an upper surface of the substrate 100 as a seed. In an example embodiment, the first channel layer 120 may include, e.g., single crystalline silicon, and the first sacrificial layer 110 may include a material having an etching selectivity with respect to the first channel layer 120, e.g., single crystalline silicon-germanium. Alternatively, the first channel layer 120 may include, e.g., single crystalline silicon-germanium, and the first sacrificial layer 110 may include, e.g., single crystalline silicon.

FIGS. 8 and 9 show that the first sacrificial layers 110 are formed at six levels, respectively, and the first channel layers 120 are formed at six levels, respectively, however, the inventive concept is not necessarily limited thereto.

In example embodiments, thicknesses in the third direction D3 of some of the first channel layers 120 may be different from thicknesses in the third direction D3 of others of the first channel layers 120. For example, thicknesses in the third direction D3 of first ones of the first channel layers 120 at (3n-2)^{th} levels (where n is a natural number), respectively, may be less than thicknesses in the third direction D3 of second ones of the first channel layers 120 at other levels, respectively. FIGS. 8 and 9 show that thicknesses in the third direction D3 of ones of the first channel layers 120 at first and fourth levels, respectively, from the upper surface of the substrate 100 are less than thicknesses in the third direction D3 of other ones of the first channel layers 120 at other levels, respectively.

The mold layer may be partially removed by an etching process to form a first opening extending through the mold layer and exposing the upper surface of the substrate 100, a first sacrificial division layer 130 may be formed on an inner wall of the first opening and an upper surface of the mold layer, a second sacrificial division layer 140 may be formed on the first sacrificial division layer to fill the first opening, and a planarization process may be performed on the first and second sacrificial division layers until the upper surface of the mold layer is exposed. During the etching process, an upper portion of the substrate 100 adjacent the first opening may also be partially removed, and thus the first opening may partially extend through the upper portion of the substrate 100.

The first sacrificial division layer 130 may include an oxide, e.g., silicon, and the second sacrificial division layer 140 may include an insulating nitride, e.g., silicon nitride.

In example embodiments, the planarization process may include, e.g., chemical mechanical polishing (CMP) process and/or an etch back process.

By the planarization process, a sacrificial division structure 150 including a second sacrificial division pattern 140 and a first sacrificial division pattern 130 covering a sidewall and a lower surface of the second sacrificial division pattern 140 may be formed in the first opening. In example embodiments, a plurality of sacrificial division structures 150 may be spaced apart from each other in each of the first and second directions D1 and D2, and each of the sacrificial division structures 150 may extend in the first direction D1 to a given length.

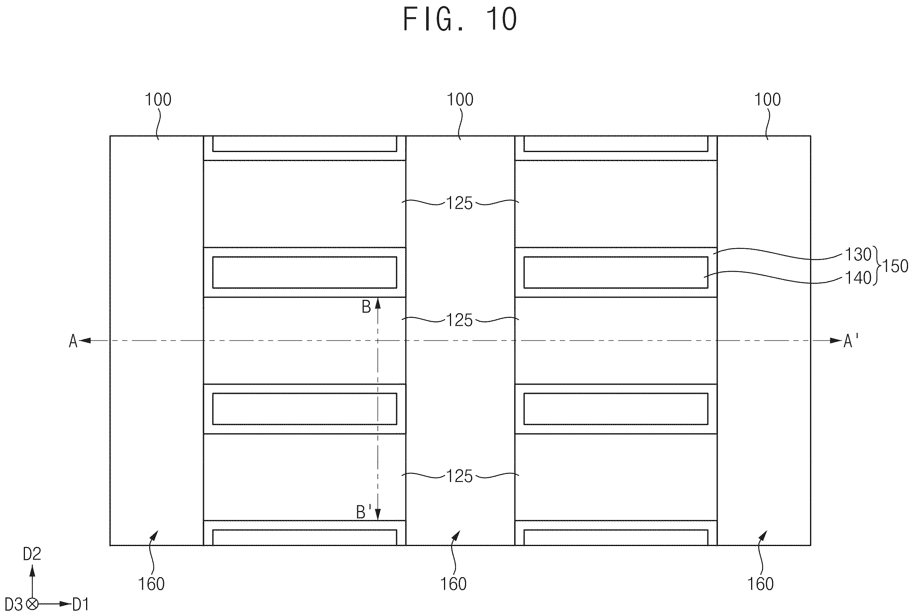

Referring to FIGS. 10 to 12, the mold layer may be partially removed by an etching process to form a second opening 160, and the first sacrificial layers 110 included in the mold layer may be removed by the second opening 160 to form first and second gaps 170 and 175.

During the etching process, the upper portion of the substrate 100 may also be partially removed so that the second opening 160 may partially extend through the upper portion of the substrate 100.

In example embodiments, the second opening 160 may extend in the second direction D2 between ones of the sacrificial division structures 150 neighboring in the first direction D1, and a plurality of second openings 160 may be spaced apart from each other in the first direction D1.

During the etching process, not only the first sacrificial layers 110 but also portions of the first channel layers 120 adjacent to upper and lower surfaces of the first sacrificial layers 110 may be removed. Thus, ones of the first channel layers 120 having relatively small thicknesses, e.g., ones of the first channel layers 120 at (3n-2)^{th} levels, respectively, from the upper surface of the substrate 100 may be entirely removed, and ones of the first channel layers 120 at other levels, respectively, from the upper surface of the substrate 100 may not be entirely removed but remain as first channels 125, respectively, having reduced thicknesses.

Thus, first and second gaps 170 and 175 may be alternately and repeatedly formed in the third direction D3 between the upper surface of the substrate 100 and a lowermost one of the first channels 125 and between ones of the first channels 125 neighboring in the third direction D3. A width in the third direction D3 of the first gap 170 may be greater than a width in the third direction D3 of the second gap 175.

A plurality of first channels 125 may be spaced apart from each other in each of the first and second directions D1 and D2 at each level.

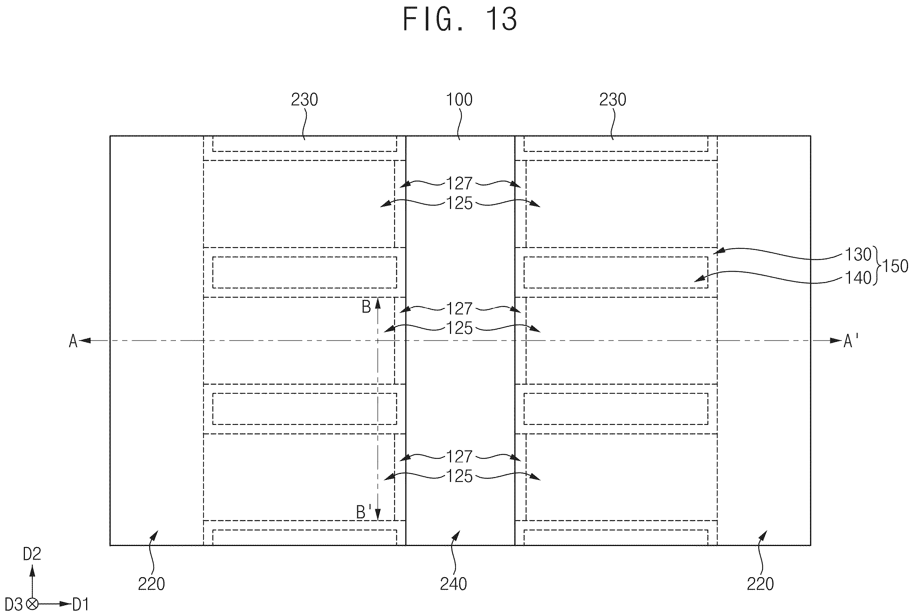

Referring to FIGS. 13 to 15, a second sacrificial layer may be formed to fill the second openings 160 and the first and second gaps 170 and 175, portions of the second sacrificial layer in some of the second openings 160 may be removed to form the second openings 160, and a sacrificial insulation structure 220 may be formed in each of the second openings 160.

In example embodiments, portions of the second sacrificial layer in first ones of the second openings 160 at, e.g., even-numbered positions among the second openings 160 arranged in the first direction D1 may be removed, so that the sacrificial insulation structure 220 may be formed in each of the first ones of the second openings 160 at the even-numbered positions.

The second sacrificial layer may include an oxide, e.g., silicon oxide. In an example embodiment, the sacrificial insulation structure 220 may include a third insulation pattern 210, a second sacrificial insulation pattern 200 covering a sidewall and a lower surface of the third insulation pattern 210, and a first sacrificial insulation pattern 190 covering a sidewall and a lower surface of the second insulation pattern 200. Each of the first and third sacrificial insulation patterns 190 and 210 may include an oxide, e.g., silicon oxide, and the second sacrificial insulation pattern 200 may include an insulating nitride, e.g., silicon nitride.

A first mask 230 may be formed on the first channels 125, the sacrificial division structures 150 and the sacrificial insulation structures 220, and an etching process may be performed on the second sacrificial layer using the first mask 230 as an etching mask to form a third opening 240 exposing the upper surface of the substrate 100.

In example embodiments, the first mask 230 may extend in the second direction D2, and a plurality of first masks 230 may be spaced apart from each other in the first direction D1. The third opening 240 may be formed by removing portions of the second sacrificial layer in second ones of the second openings 160 at, e.g., odd-numbered positions among the second openings 160 arranged in the first direction D1, and a second sacrificial pattern 180 may remain in each of the first and second gaps 170 and 175.

For example, a gas phase deposition (GPD) process may be performed to form a first impurity region 127 on a sidewall in the first direction D1 of each of the first channels 125 exposed by the third opening 240. In example embodiments, the first impurity region 127 may include p-type impurities, e.g., boron, aluminum, etc.

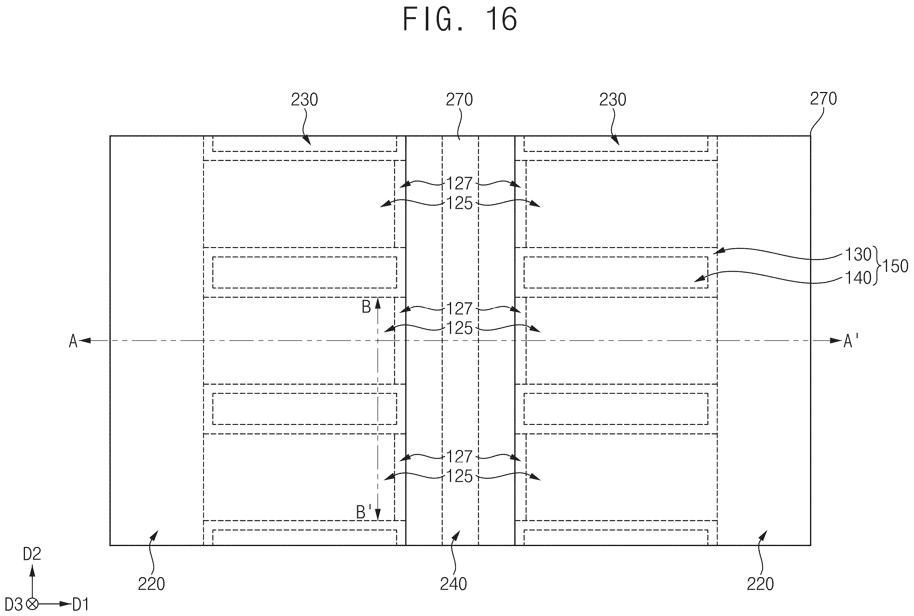

FIGS. 16 to 18, for example, a wet etching process may be performed to remove the second sacrificial patterns 180 through the third opening 240 so that the first and second gaps 170 and 175 may be formed again, and first and second insulation layers 260 and 270 may be sequentially formed on inner walls of the first and second gaps 170 and 175, surfaces of the first channels 125, sidewalls of the sacrificial insulation structures 220 and sidewalls and upper surfaces of the first masks 230.

The second gap 175 having a relatively small width in the third direction D3 may be entirely filled with the first and second insulation layers 260 and 270, while the first gap 170 having a relatively large width in the third direction D3 may be partially filled with the first and second insulation layers 260 and 270.

The first insulation layer 260 may include an oxide, e.g., silicon oxide, and the second insulation layer 270 may include an insulating nitride, e.g., silicon nitride.

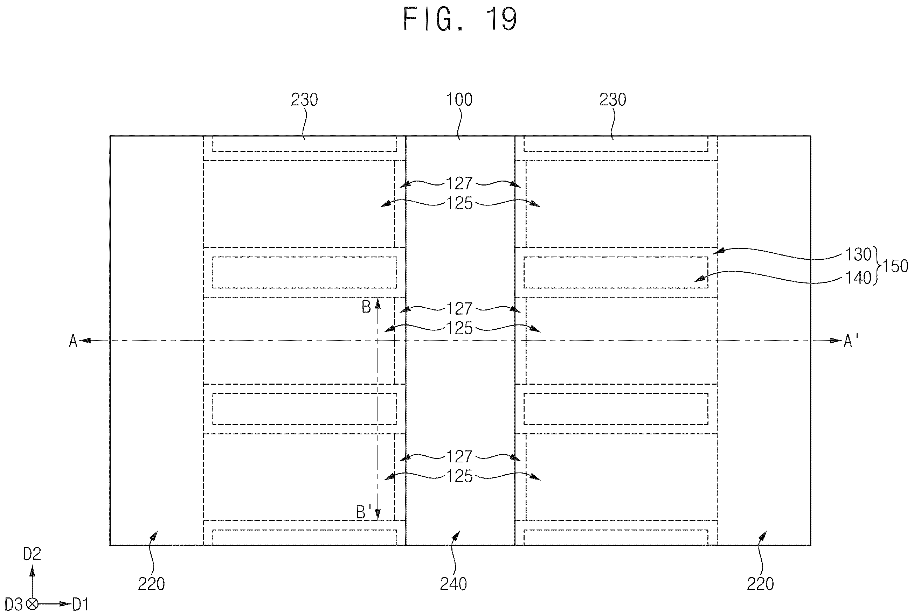

Referring to FIGS. 19 to 21, for example, a wet etching process may be performed on the first and second insulation layers 260 and 270 so that portions of the first and second insulation layers 260 and 270 on the sidewalls and the upper surfaces of the first masks 230, sidewalls of the first channels 125 and the upper surfaces of the substrate 100 may be removed.

During the wet etching process, portions of the first and second insulation layers 260 and 270 in the first gap 170 having the relatively large width may be entirely removed. A portion of the second insulation layer 270 adjacent to the third opening 240 in the second gap 170 having the relatively small width may be removed to form a first recess 272, and the second insulation layer 270 may be transformed into a second insulation pattern 275. A portion of the first insulation layer 260 in the second gap 175 may remain as a first insulation pattern 265.

A deposition process and an etching process may be further performed to form a third sacrificial pattern 280 in the recess 272. The third sacrificial pattern 280 may include an oxide, e.g., silicon oxide.

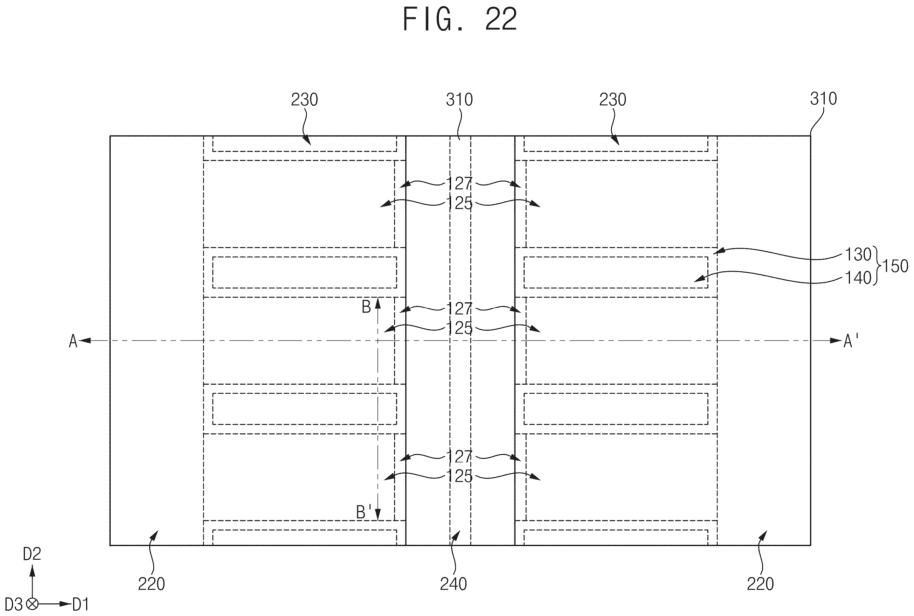

Referring to FIGS. 22 to 24, a high-k dielectric layer 290, a third insulation layer 300 and a fourth insulation layer 310 may be sequentially formed on the upper surfaces and the sidewalls of the first masks 230, sidewalls of the first channels 125, the first insulation patterns 265 and the third sacrificial patterns 280, the inner walls of the first gaps 170 and the upper surface of the substrate 100 by a deposition process, e.g., a chemical vapor deposition (CVD) process, an atomic layer deposition (ALD) process, etc.

During the deposition process, a central portion of the third opening 240 may not be filled with the high-k dielectric layer 290, the third insulation layer 300 and the fourth insulation layer 310.

The third insulation layer 300 may include an insulating nitride, e.g., silicon nitride, the fourth insulation layer 310 may include an oxide, e.g., silicon oxide, and the high-k dielectric layer 290 may include a metal oxide having a high dielectric constant.

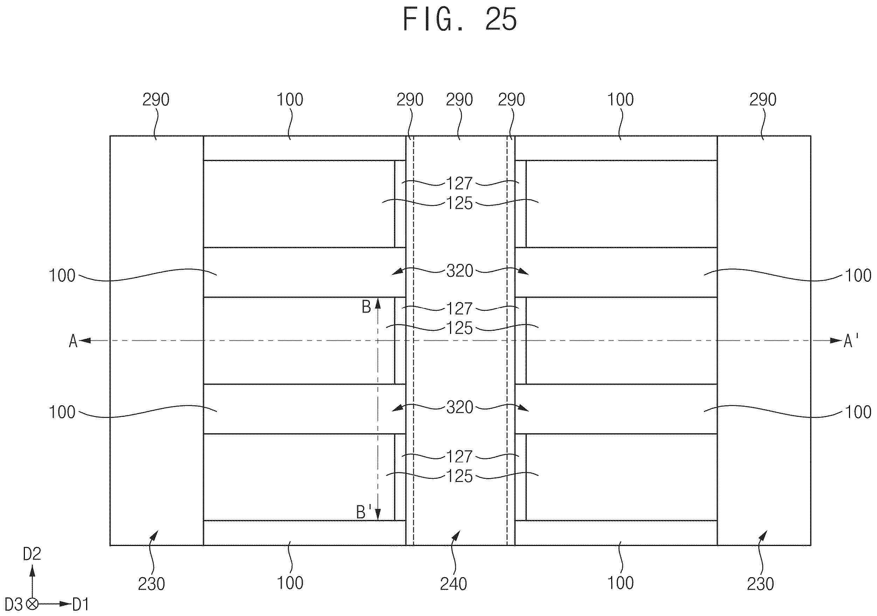

Referring to FIGS. 25 to 27, for example, a wet etching process may be performed on the third and fourth insulation layers 300 and 310, and third and fourth insulation patterns 305 and 315 may remain in the first gap 170.

A portion of the first mask 230 on the first channels 125 and the sacrificial division structures 150 and a portion of the high-k dielectric layer 290 on an upper surface of the portion of the first mask 230 may be removed to expose upper surfaces of the sacrificial division structures 150, and for example, a wet etching process may be performed on the sacrificial division structures 150 to form fourth openings 320 exposing the upper surface of the substrate 100.

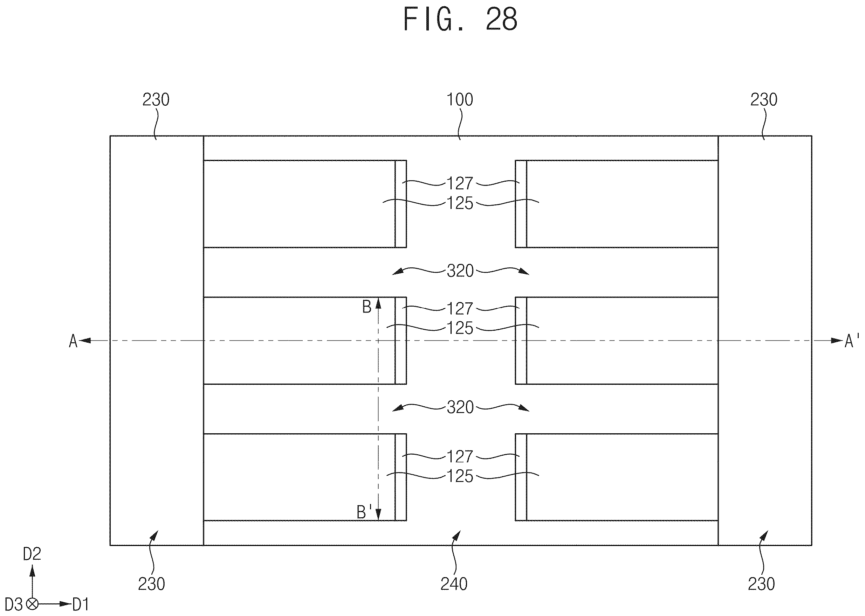

Referring to FIGS. 28 to 30, for example, a wet etching process may be performed so that portions of the high-k dielectric layer 290 and the third insulation patterns 305 adjacent to the third and fourth openings 240 and 320 may be removed.

Thus, a portion of the high-k dielectric layer 290 on the upper surfaces of the first masks 230, the sidewalls of the first channels 125, the first insulation patterns 265 and the third sacrificial patterns 280, and the upper surface of the substrate 100 may be removed to form a high-k dielectric pattern 295.

During the wet etching process, portions of the third insulation pattern 305 and the high-k dielectric layer 290 that are disposed on the opposite sidewalls in the second direction D2 of each of the fourth insulation patterns 315 may also be removed.

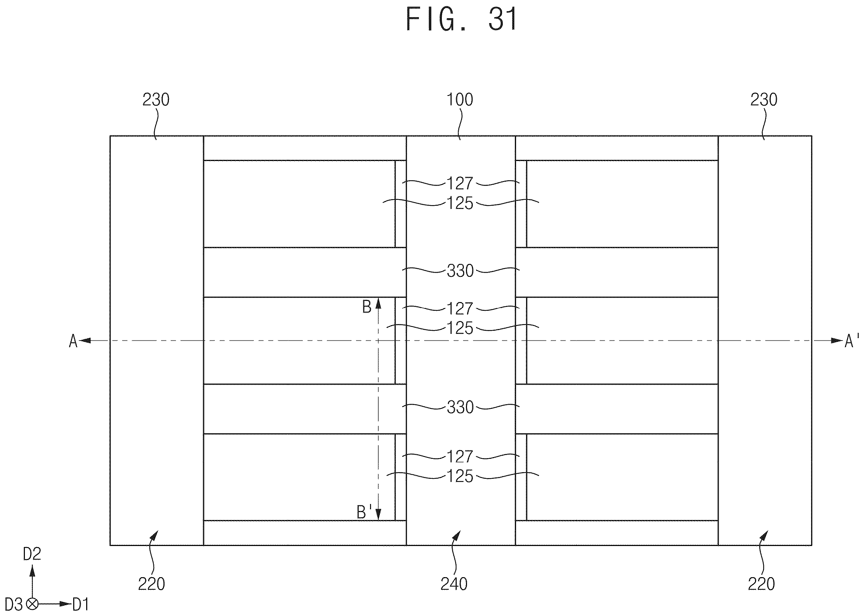

Referring to FIGS. 31 to 33, a fifth insulation layer 330 may be formed to fill the fourth opening 320, and an etching process may be performed through the third opening 240 to partially remove the third insulation pattern 305 to form a second recess, and a first conductive pattern 340 may be formed in the second recess.

The fifth insulation layer 330 may include an oxide, e.g., silicon oxide. The first conductive pattern 340 may include a conductive material, e.g., a metal, a metal nitride, etc. The first conductive pattern 340 may store data in the semiconductor device, and thus may also be referred to as a data storage pattern 340.

The first conductive pattern 340 may be partially removed by an etching process through the third opening 240 to form a third recess, and a second channel 350 may be formed in the third recess. In example embodiments, the second channel 350 may include an oxide semiconductor material doped with impurities, for example, n-type oxide semiconductor material doped with hydrogen, oxygen, etc., or a p-type oxide semiconductor material doped with hydrogen, oxygen, etc. By adjusting a concentration of the impurities, third and fourth impurity regions 357 and 359 may be formed at edge portions in the first direction D1 of the second channel 350.

Alternatively, the first conductive pattern 340 and the second channel 350 may be formed by the same deposition process.

Particularly, the third insulation pattern 305 may be partially removed to form the second recess, the first conductive pattern 340 and the second channel 350 may be sequentially formed in the second recess. Each of the first conductive pattern 340 and the second channel 350 may include the same oxide semiconductor material. By controlling the concentration of the impurities, the first conductive pattern 340 may be formed to have a first impurity concentration, the third and fourth impurity regions 357 and 359 may be formed to have a second impurity concentration less than the first impurity concentration, and the second channel 350 may be formed to have a third impurity concentration less than the second impurity concentration.

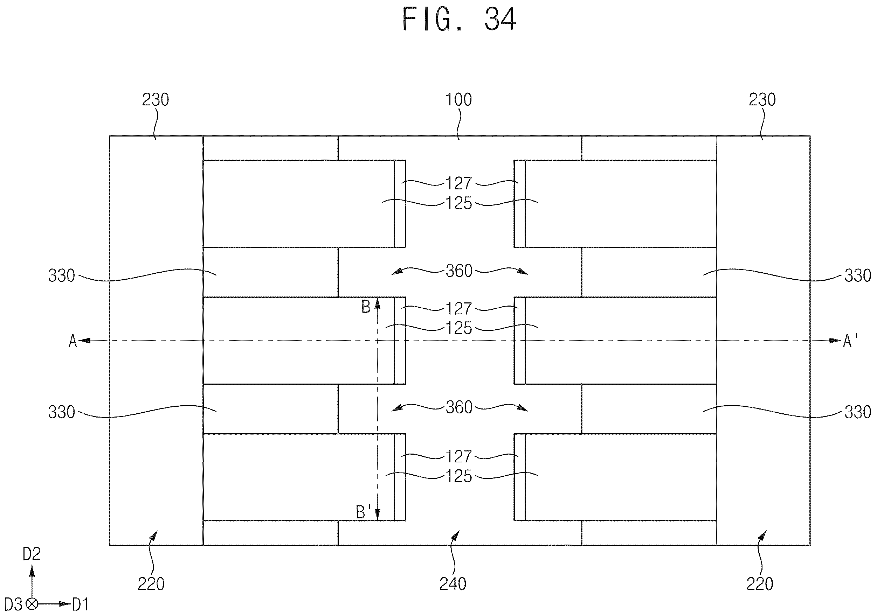

Referring to FIGS. 34 to 36, for example, a wet etching process may be performed to remove portions of the fifth insulation layers 330 and the fourth insulation pattern 315 adjacent to the third opening 240 and the third sacrificial patterns 280.

Thus, a fifth opening 360 may be formed to expose the upper surface of the substrate 100 between ones of the first channels 125 neighboring in the second direction D2, a third gap 362 may be formed between ones of the second channels 350 neighboring in the third direction D3 and between ones of the first conductive patterns 340 neighboring in the third direction D3, and the first recess 272 may be formed again on a sidewall in the first direction D1 of the second insulation pattern 275.

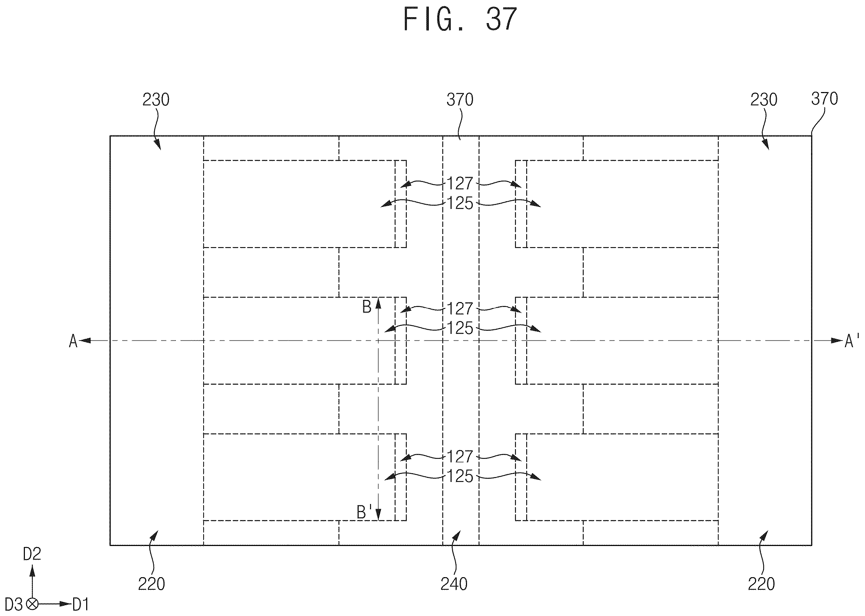

Referring to FIGS. 37 to 39, a fourth sacrificial layer 370 may be formed on the sidewalls and the upper surfaces of the first mask 230, the sidewalls and the upper surfaces of the first channels 125, the sidewalls of the first and second insulation patterns 265 and 275 and the second channels 350, the upper surface of the substrate 100 and inner walls of the third gaps 362 to fill the fifth openings 360 and the first recesses 272.

In an example embodiment, the fourth sacrificial layer 370 may not entirely but partially fill each of the third gaps 362. The fourth sacrificial layer 370 may include an oxide, e.g., silicon oxide, and the fifth insulation layer 330 may be merged to the fourth sacrificial layer 370.

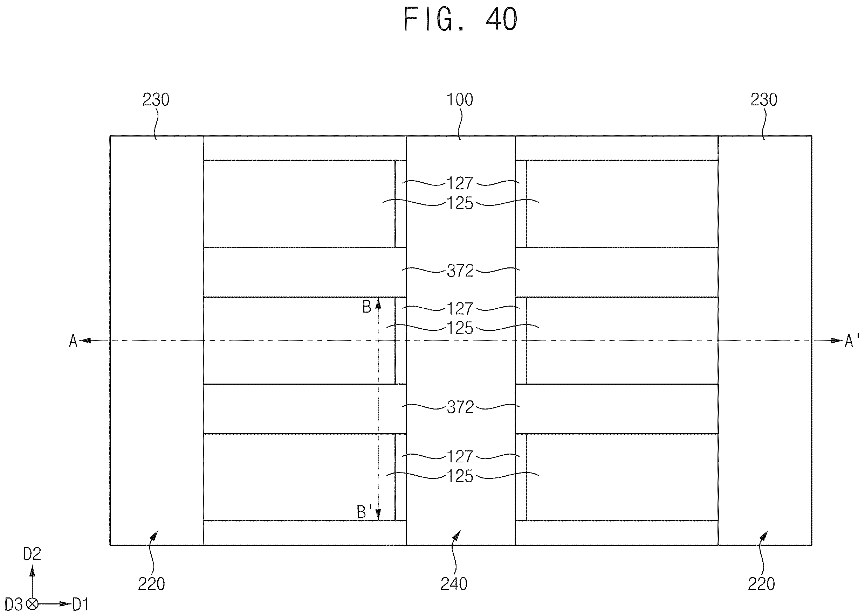

Referring to FIGS. 40 to 42, for example, a wet etching process may be performed to partially remove the fourth sacrificial layer 370.

Thus, portions of the fourth sacrificial layer 370 on the sidewalls and the upper surfaces of the first masks 230, the upper surfaces and the sidewalls of the first channels 125, the sidewalls of the first and second insulation patterns 265 and 275 and the second channels 350, the upper surface of the substrate 100 and the inner walls of the third gaps 362 may be removed.

However, a portion of the fourth sacrificial layer 370 between ones of the second insulation patterns 275 neighboring in the second direction D2 at each level may remain as a fourth sacrificial pattern 372 in the fifth opening 360, and a portion of the fourth sacrificial layer 370 in the first recess 272 may remain as a fifth insulation pattern 376.

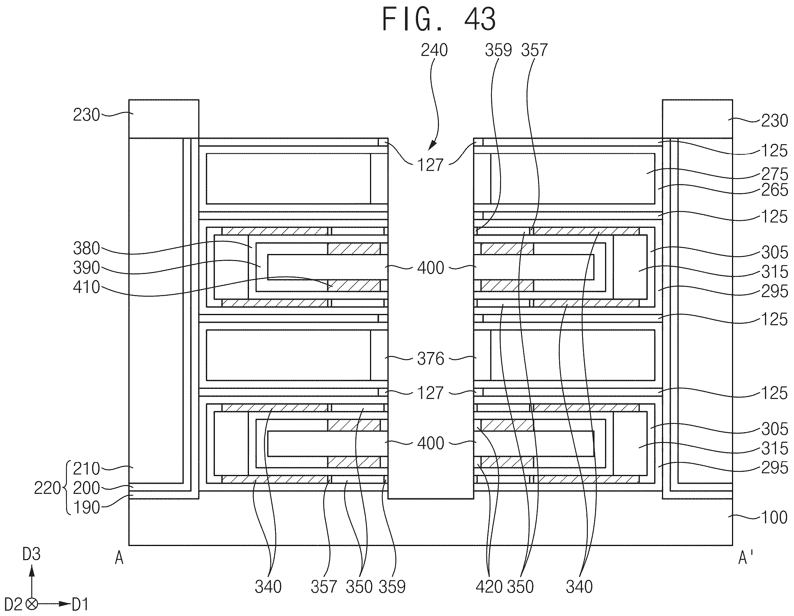

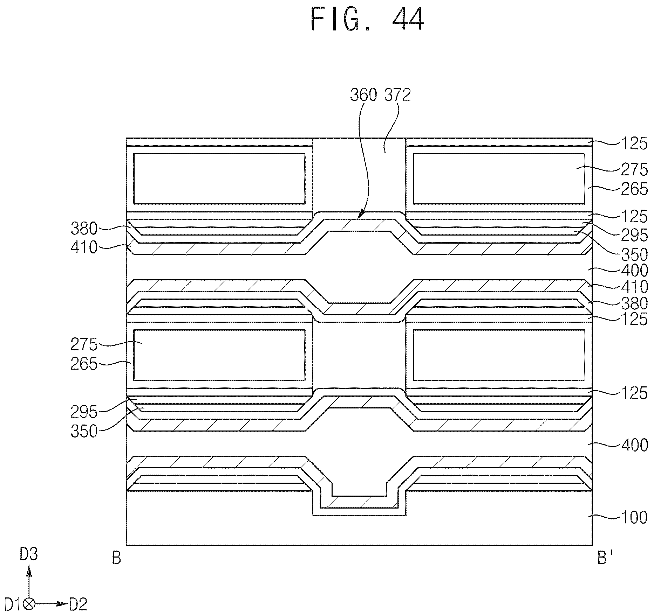

Referring to FIGS. 43 and 44, a second gate insulation layer and a sixth insulation layer may be sequentially stacked on the sidewalls and the upper surfaces of the first masks 230, the upper surfaces and the sidewalls of the first channels 125, lower and upper surfaces of the fourth sacrificial patterns 372, the sidewalls of the first and second insulation patterns 265 and 275 and the second channels 350, the upper surface of the substrate 100 and the inner walls of the third gaps 362, and a seventh insulation layer may be formed on the sixth insulation layer to fill the third gaps 362.

For example, a wet etching process may be performed on the second gate insulation layer and the sixth and seventh insulation layers to form a seventh insulation pattern 400, a sixth insulation pattern 390 covering a sidewall in the first direction D1 and lower and upper surfaces of the seventh insulation pattern 400, and a second gate insulation pattern 380 covering a sidewall in the first direction D1 and lower and upper surfaces of the sixth insulation pattern 390 in each of the third gaps 362.

An etching process may be performed on the sixth insulation pattern 390 through the third opening 240 to form a fourth recess, and a second conductive pattern 410 may be formed in the fourth recess. The second conductive pattern 410 may serve as a word line in the semiconductor device, and thus may also be referred to as a second word line 410. A portion of the second conductive pattern 410 may serve a gate electrode of the semiconductor device. The portion of the second conductive pattern 410 and the second gate insulation pattern 380 may collectively form a second gate structure. The second gate structure and the second channel 350 may collectively form a second transistor.

An etching process may be performed through the third opening 240 so that the second conductive pattern 410 may be partially removed to form a fifth recess, and a second capping pattern 420 may be formed in the fifth recess.

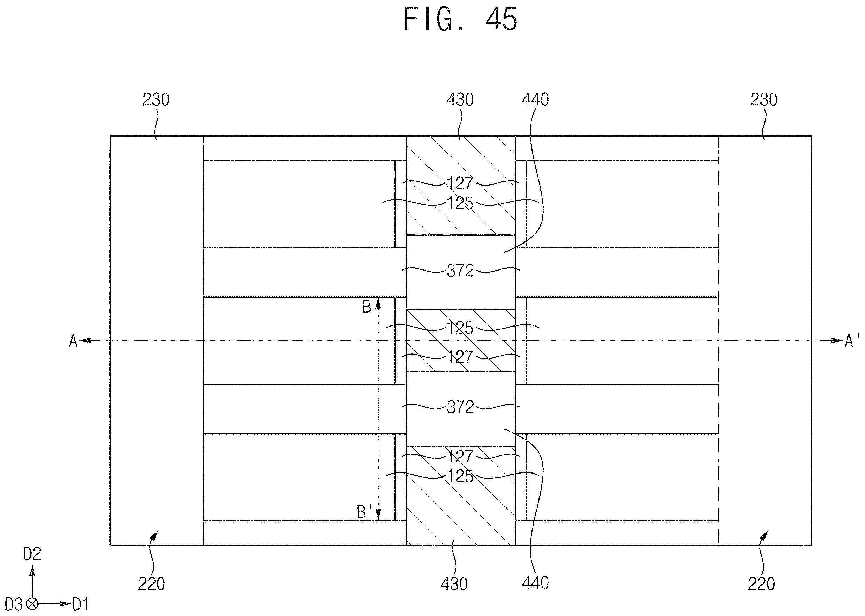

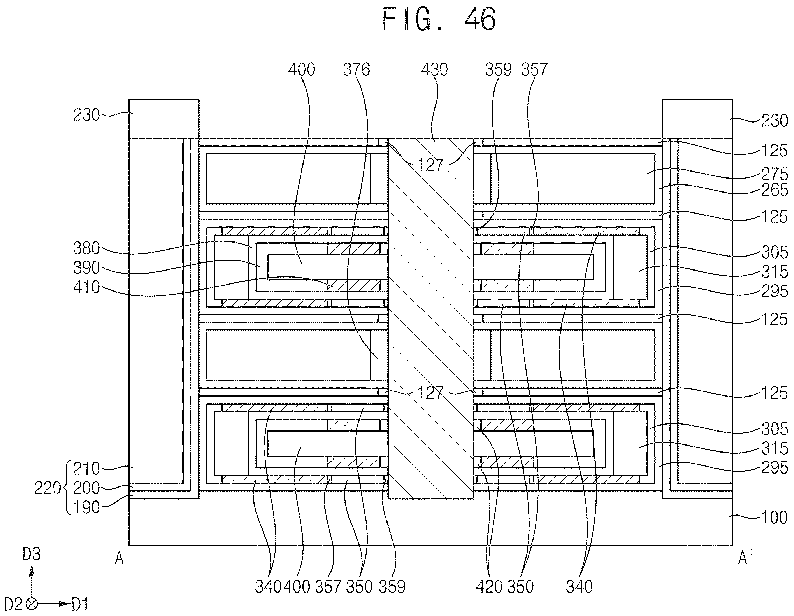

Referring to FIGS. 45 and 46, a bit line layer may be formed in the third opening 240, and division layers 440 may be formed through the bit line layer to be spaced apart from each other in the second direction D2 so that the bit line layer may be divided into a plurality of bit lines 430 spaced apart from each other in the second direction D2 by the division layers 440.

In example embodiments, each of the division layers 440 may extend in the third direction D3 between ones of the fourth sacrificial patterns 372 neighboring in the first direction D1, and thus each of the bit lines 430 may extend in the third direction D3 between ones of the first channels 125 neighboring in the first direction D1.

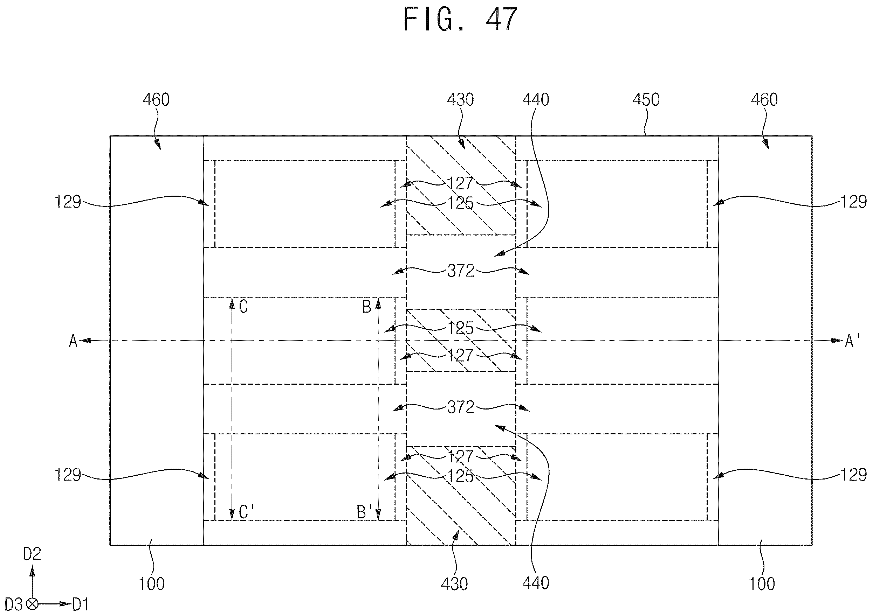

Referring to FIGS. 47 to 49, the first masks 230 may be removed, a second mask 450 may be formed to cover the bit lines 430, the division layers 440 and the first channels 125 and expose upper surfaces of the sacrificial insulation structures 220, and an etching process may be performed to remove the sacrificial insulation structures 220, and thus a sixth opening 460 exposing the upper surface of the substrate 100 may be formed.

In example embodiments, the second mask 450 may extend in the second direction D2, and a plurality of second masks 450 may be spaced apart from each other in the first direction D1. The sixth opening 460 may extend in the second direction D2, and a plurality of sixth openings 460 may be spaced apart from each other in the first direction D1.

For example, a GPD process may be performed to form a second impurity region 129 on a sidewall in the first direction D1 of each of the first channels 125 exposed by the sixth opening 460. In example embodiments, the second impurity region 129 may include p-type impurities, e.g., boron, aluminum, etc.

Each of the second insulation patterns 275 may be partially removed through the sixth openings 460 to form a fourth gap 470.

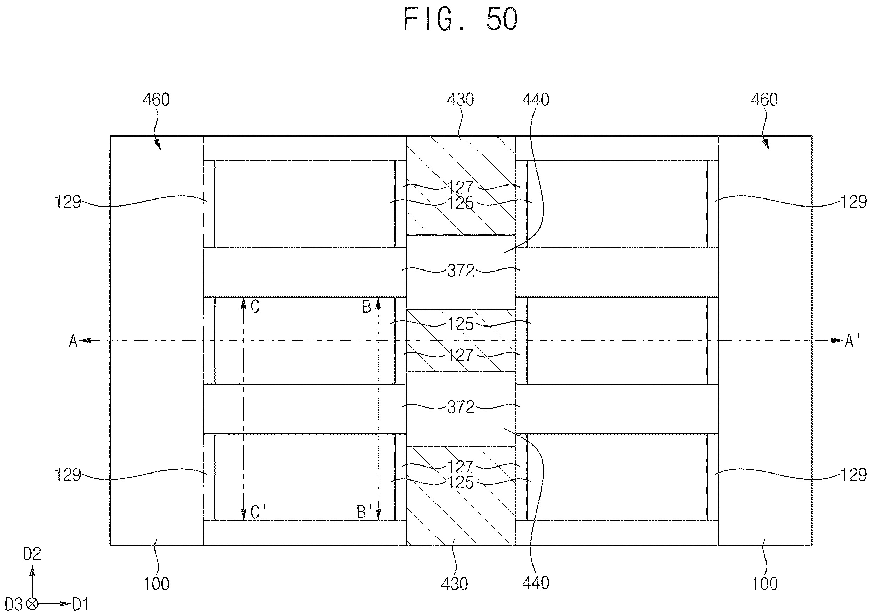

Referring to FIGS. 50 to 52, for example, a wet etching process may be performed so that portions of the first insulation pattern 265 and the fourth sacrificial pattern 372 exposed by the fourth gap 470 may be removed, and thus a fifth gap extending in the second direction D2 may be formed between the ones of the first channels 125 neighboring in the third direction D3.

However, a portion of the first insulation pattern 265 on lower and upper surfaces of the second insulation pattern 275 and the fifth insulation pattern 376 may remain. A portion of the fourth sacrificial pattern 372 between uppermost ones of the first channels 125 and a portion of the fourth sacrificial pattern 372 adjacent to the division layer 440 may not be removed but may remain as an eighth insulation pattern 374.

After removing the second mask 450, a first gate insulation layer and a ninth insulation layer may be sequentially stacked on the surfaces of the first channels 125, surfaces of the eighth insulation patterns 374, sidewalls of the high-k dielectric patterns 295, the upper surface of the substrate 100 and inner walls of the fifth gaps, and a tenth insulation layer may be formed on the ninth insulation layer to fill the third gaps 362.

For example, a wet etching process may be performed on the first gate insulation layer and the ninth and tenth insulation layers to form a tenth insulation pattern 500, a ninth insulation pattern 490 covering a sidewall in the first direction D1 and lower and upper surfaces of the tenth insulation pattern 500, and a first gate insulation pattern 480 covering a sidewall in the first direction D1 and lower and upper surfaces of the ninth insulation pattern 490.

An etching process may be performed on the ninth insulation pattern 490 through the sixth opening 460 to form a sixth recess, and a third conductive pattern 510 may be formed in the sixth recess. The third conductive pattern 510 may serve as a word line in the semiconductor device, and thus may also be referred to as a first word line 510. A portion of the third conductive pattern 510 may serve as a first gate electrode of the semiconductor device. The portion of the third conductive pattern 510 and the first gate insulation pattern 480 may collectively form a first gate structure, and the first gate structure and the first channel 125 may collectively form a first transistor.

An etching process may be performed on the third conductive pattern 510 through the sixth opening 460 to form a seventh recess, and a first capping pattern 520 may be formed in the seventh recess.

Referring to FIGS. 1 to 5 again, a plate line 540 may be formed in the sixth opening 460 to complete the fabrication of the semiconductor device.

The plate line 540 may extend in the second direction D2, and a plurality of plate lines 540 may be spaced apart from each other in the first direction D1.

While the present inventive concepts have been shown and described with reference to example embodiments thereof, it will be understood by those of ordinary skill in the art that various changes in form and details may be made thereto without departing from the spirit and scope of the present inventive concepts as set forth by the following claims.

## Claims

1. A semiconductor device comprising:
a bit line on a substrate;
a plate line on the substrate, the plate line being spaced apart from the bit line in a first direction substantially parallel to an upper surface of the substrate facing the bit line;
a first channel between the bit line and the plate line;
a first word line wherein the first channel is between the first word line and the substrate, the first word line extending in a second direction substantially parallel to the upper surface of the substrate and crossing the first direction;
a second channel between the first channel and the substrate;
a data storage pattern between the bit line and the plate line at a same distance from the substrate as the second channel; and
a second word line between the second channel and the substrate, the second word line extending in the second direction.

2. The semiconductor device according to claim 1, wherein the data storage pattern includes a metal or a metal nitride.

3. The semiconductor device according to claim 1, wherein the data storage pattern includes an oxide semiconductor material doped with impurities.

4. The semiconductor device according to claim 3, wherein the second channel includes an oxide semiconductor material doped with impurities.

5. The semiconductor device according to claim 4, wherein a concentration of the impurities doped in the data storage pattern is greater than a concentration of the impurities doped in the second channel.

6. The semiconductor device according to claim 1, wherein each of the first and second channels has a shape of a flat plate, and
wherein the second channel overlaps a portion of the first channel in a third direction substantially perpendicular to the upper surface of the substrate.

7. The semiconductor device according to claim 6, wherein the data storage pattern overlaps a portion of the first channel in the third direction.

8. The semiconductor device according to claim 7, wherein the data storage pattern overlaps a portion of the first word line in the third direction.

9. The semiconductor device according to claim 1, further comprising first and second impurity regions at opposite ends of the first channel, respectively, in the first direction, the first and second impurity regions contacting the bit line and the plate line, respectively.

10. The semiconductor device according to claim 9, further comprising third and fourth impurity regions at opposite ends of the second channel, respectively, in the first direction, the third and fourth impurity regions contacting the data storage pattern and the bit line, respectively.

11. The semiconductor device according to claim 10, wherein each of the first and second impurity regions includes a semiconductor material doped with impurities having a first conductivity type, and
wherein each of the third and fourth impurity regions includes an oxide semiconductor material having a second conductivity type and doped with hydrogen or oxygen.

12. The semiconductor device according to claim 1, wherein the first and second word lines do not overlap each other in a third direction substantially perpendicular to the upper surface of the substrate.

13. A semiconductor device comprising:
a bit line on a substrate;
a plate line on the substrate, the plate line being spaced apart from the bit line in a first direction substantially parallel to an upper surface of the substrate facing the bit line;
a first transistor including:
a first channel between the bit line and the plate line;
first and second source/drain regions at opposite ends of the first channel, respectively, in the first direction, the first and second source/drain regions contacting the bit line and the plate line, respectively;
a first gate insulation pattern on the first channel and the first and second source/drain regions; and
a first gate electrode on the first gate insulation pattern, wherein the first gate insulation pattern is between the channel and the first gate electrode;
a second transistor including:
a second channel between the first channel and the substrate;
third and fourth source/drain regions at opposite ends of the second channel, respectively, in the first direction;
a second gate insulation pattern between the substrate and the second channel and the third and fourth source/drain regions; and
a second gate electrode between the second gate insulation pattern and the substrate; and
a data storage pattern at a same distance from the substrate as the second channel, the data storage pattern contacting the third source/drain,
wherein the fourth source/drain region contacts the bit line.

14. The semiconductor device according to claim 13, wherein:
the first channel includes a single crystalline semiconductor material,
each of the first and second source/drain regions includes the single crystalline semiconductor material doped with a first conductivity type of impurities,
the second channel includes an oxide semiconductor material having a second conductivity type, and
each of the third and fourth source/drain regions includes the oxide semiconductor material doped with hydrogen or oxygen.

15. The semiconductor device according to claim 14, wherein the data storage pattern includes the oxide semiconductor material doped with hydrogen or oxygen, and
wherein a concentration of hydrogen or oxygen doped in the data storage pattern is greater than a concentration of hydrogen or oxygen doped in each of the third and fourth source/drain regions.
